# EUROPEAN PATENT APPLICATION

(11) **EP 2 452 964 A1**
(43) Date of publication of application: **16.05.2012**
(21) Application number: 10797017.0
(22) Date of filing: 23.06.2010
(51) Int. Cl.: C08G 59/40, C08G 73/10, C08L 63/00, C08L 79/08, C09J 163/00, C09J 179/08, H01L 21/60, H01L 23/29, H01L 23/31

(54) **ADHESIVE COMPOSITION, ADHESIVE SHEET, CIRCUIT BOARD AND SEMICONDUCTOR DEVICE BOTH PRODUCED USING THESE, AND PROCESSES FOR PRODUCING THESE**

(30) Priority: 10.07.2009 JP 2009163403; 25.05.2010 JP 2010119026
(71) Applicant: Toray Industries, Inc., Tokyo, 103-8666 (JP)
(72) Inventor: FUJIMARU, Koichi, Otsu-shi Shiga 520-8558 (JP); NONAKA, Toshihisa, Otsu-shi Shiga 520-8558 (JP); TATSUTA, Yoshiko, Otsu-shi Shiga 520-8558 (JP)
(74) Representative: Hager, Thomas Johannes
(86) International application number: PCT/JP2010/060622
(87) International publication number: WO 2011/004706

(57) **Abstract**

Provided is an adhesive composition having both excellent storability and excellent connection reliability. The adhesive composition comprises (a) a polyimide soluble in organic solvents, (b) an epoxy compound, (c) particles of a curing accelerator, and (d) inorganic particles, the amounts of the organic-solvent-soluble polyimide (a) and the curing-accelerator particles (c) being 15-90 parts by weight and 0.1-50 parts by weight, respectively, per 100 parts by weight of the epoxy compound (b), and the content of the inorganic particles (d) being 30-80 wt.% of the total amount of (a) to (d).

## Description

### TECHINICAL FIELD

The present invention relates to an adhesive composition or the like that can be used for bonding of electronic parts for use in personal computers or mobile computers, bonding between a radiator plate and a printed substrate or a flexible substrate, and bonding between substrates. More specifically, the present invention relates to an adhesive composition or the like for use in bonding or direct electrical connection of a semiconductor chip such as IC or LSI to a circuit board such as a flexible substrate, a glass epoxy substrate, a glass substrate, a ceramic substrate, a silicon interposer, or a silicon substrate or in connection between semiconductor chips or stacking of semiconductor chips such as three-dimensional assembly.

### BACKGROUND ART

In recent years, flip chip assembly has received attention and has been rapidly spreading as a technique for mounting a semiconductor chip on a circuit board due to downsizing and density growth of semiconductor devices. In flip chip assembly, an epoxy resin-based adhesive is generally interposed between a semiconductor chip and a circuit board to ensure the connection reliability of joints between bump electrodes formed on the semiconductor chip and pad electrodes of the circuit board. Particularly, adhesives containing a polyimide resin, an epoxy resin, and inorganic particles are being frequently used for various applications such as electrical and electronic applications, architecture, automobiles, and airplanes by virtue of the heat resistance and insulation properties of the polyimide resin, the adhesiveness and water resistance of the epoxy resin, and the low water absorbency and low thermal expansibility of the inorganic particles (see, for example, Patent Documents 1 to 7).

However, such adhesives have a problem in that reaction gradually proceeds at room temperature during storage. For this reason, there has been a demand for development of an adhesive capable of being stored at room temperature for several months. On the other hand, the use of a microcapsule-type hardening accelerator has been proposed as a technique for improving storage stability at room temperature (see, for example, Patent Document 8).

### PRIOR ART DOCUMENTS

### PATENT DOCUMENTS

Patent Document 1: Japanese Patent Laid-open Publication No. 2004-319823
Patent Document 2: Japanese Patent Laid-open Publication No. 6-264035
Patent Document 3: Japanese Patent Laid-open Publication No. 2006-144022
Patent Document 4: Japanese Patent Laid-open Publication No. 2009-007531
Patent Document 5: Japanese Patent Laid-open Publication No. 2008-094870
Patent Document 6: Japanese Patent No. 3995022
Patent Document 7: Japanese Patent Laid-open Publication No. 2009-117813
Patent Document 8: Japanese Patent Laid-open Publication No. 2006-77258

### DISCLOSURE OF THE INVENTION

### PROBLEMS TO BE SOLVED BY THE INVENTION

In the case of a conventional adhesive, a hardening reaction proceeds gradually during storage or in a semiconductor chip assembly process, and therefore there is a case where unstable electrical connection is caused because bump electrodes of a semiconductor chip are less likely to penetrate the adhesive or there is a case where connection reliability is poor because air bubbles are trapped in the adhesive. Further, a semiconductor device produced using such a conventional adhesive also has a problem in that it is difficult to maintain sufficient connection reliability when the semiconductor device is subjected to a process where higher durability is required such as a moisture absorption-reflow process or a thermal cycle process.

In order to solve these problems, it is therefore an object of the present invention to provide an adhesive composition excellent in both storage stability and connection reliability.

### SOLUTIONS TO THE PROBLEMS

In order to achieve the above object, the present invention is directed to an adhesive composition comprising: an organic-solvent-soluble polyimide (a); an epoxy compound (b); hardening accelerator particles (c); and inorganic particles (d), wherein an organic-solvent-soluble polyimide (a) content and a hardening accelerator particle (c) content are 15 to 90 parts by weight and 0.1 to 50 parts by weight, respectively, with respect to 100 parts by weight of the epoxy compound (b), and an inorganic particle (d) content is 30 wt% or more but 80 wt% or less with respect to a total amount of (a) to (d).

### EFFECTS OF THE INVENTION

According to the present invention, it is possible to obtain an adhesive composition excellent in both storage stability and connection reliability.

### BRIEF DESCRIPTION OF THE DRAWING

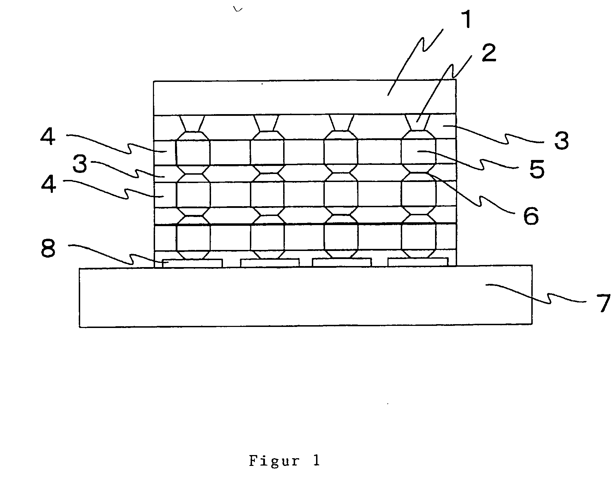

Fig. 1 is a schematic diagram of a circuit board with a semiconductor having three silicon interposer layers.

### MODE FOR CARRYING OUT THE INVENTION

An adhesive composition according to the present invention comprises: an organic-solvent-soluble polyimide (a); an epoxy compound (b); hardening accelerator particles (c); and inorganic particles (d), wherein an organic-solvent-soluble polyimide (a) content and a hardening accelerator particle (c) content are 15 to 90 parts by weight and 0.1 to 50 parts by weight, respectively, with respect to 100 parts by weight of the epoxy compound (b), and an inorganic particle (d) content is 30 wt% or more but 80 wt% or less with respect to a total amount of (a) to (d).

The adhesive composition according to the present invention contains the organic-solvent-soluble polyimide (a) having imide rings, and is therefore excellent in heat resistance and chemical resistance. Particularly, a composition having a higher-density network structure can be obtained by using an organic-solvent-soluble polyimide having, in its side chain, at least one functional group reactable with an epoxy group because ring-opening of the epoxy compound and an addition reaction to an aromatic polyimide are accelerated during heat treatment. Examples of the functional group reactable with an epoxy group include a phenolic hydroxyl group, a sulfonic acid group, and a thiol group. A method for synthesizing such an aromatic polyimide is not particularly limited, but an example thereof is a method in which an acid dianhydride having a group reactable with an epoxy group is first reacted with a diamine to synthesize a polyimide precursor, and then the polyimide precursor is subjected to end modification using a primary monoamine as an end capping agent, and is then subjected to heat treatment at 150°C or higher to perform polyimide cyclization. Alternatively, the following method may be used. An acid dianhydride is reacted with a primary monoamine as an end capping agent in advance, and then a diamine is added to synthesize an end-modified polyimide precursor, and the polyimide precursor is subjected to heat treatment at a high temperature of 150°C or higher to perform polyimide cyclization.

A preferred example of the organic-solvent soluble polyimide (a) used in the present invention is a polymer having a structural unit represented by the following general formula (2), at least one functional group reactable with an epoxy group in its side chain, a structure (s) represented by the following general formula (3) and/or the following general formula (4) at least one of the ends of its main chain, and a structure represented by the following general formula (1) as R⁴ in the general formula (2) in an amount of 5 to 15 wt% with respect to the total amount of the polymer. By setting the amount of a structure represented by the general formula (1) contained in the polymer to 5 wt% or more, it is possible to impart appropriate flexibility to a rigid polyimide, and by setting the amount of a structure represented by the general formula (1) contained in the polymer to 15 wt% or less, it is possible to maintain the rigidity of a polyimide skeleton to keep heat resistance and insulation properties.

It is to be noted that the total amount of the polymer (polyimide) obtained by synthesis of the organic-solvent soluble polyimide refers to the weight of a polymer obtained by polymerization using a diamine, an acid dianhydride, and an end capping agent as its constituents, and does not include the weights of an excess of the diamine, an excess of the acid dianhydride, and an excess of the end capping agent which are fed during synthesis.

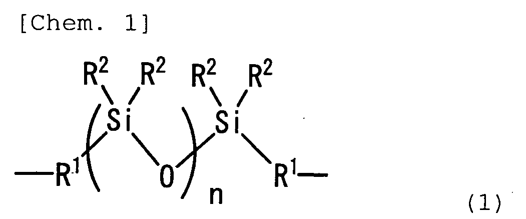

wherein R¹ is a divalent hydrocarbon group, preferably an alkylene group having 1 to 5 carbon atoms or a phenylene group, R² is a monovalent hydrocarbon group, preferably an alkyl group having 1 to 5 carbon atoms or a phenyl group, R¹s and R²s contained in one molecule of the organic-solvent-soluble polyimide may be different, and R¹s and R²s contained in different molecules of the organic-solvent-soluble polyimide may be different.

In the above general formula (1), n is an integer of 1 to 10, preferably 1 or 2. By setting n to 1 or more, it is possible to suppress the shrinkage of the adhesive composition during hardening, and by setting n to 10 or less, it is possible to improve the insulation properties and heat resistance of the adhesive composition without reducing the imide group content of the polyimide skeleton.

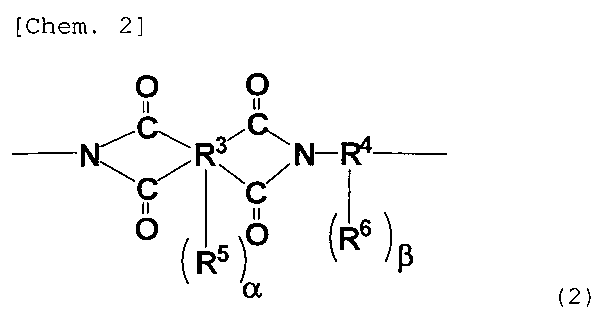

wherein R³ is a 4- to 14-valent organic group, R⁴ is a 2- to 12-valent organic group, at least one of R³ and R⁴ contains at least one group selected from the group consisting of a 1,1,1,3,3,3-hexafluoropropyl group, an isopropyl group, an ether group, a thioether group, and a SO₂ group, R⁵ and R⁶ are each a group selected from the group consisting of a phenolic hydroxyl group, a sulfonic acid group, and a thiol group, R³s, R⁴s, R⁵s, and R⁶s contained in one molecule of the organic-solvent-soluble polyimide may be different, R³s, R⁴s, R⁵s, and R⁶s contained in different molecules of the organic-solvent-soluble polyimide may be different, α and β are each an integer of 0 to 10, and α+β is an integer of 1 to 10.

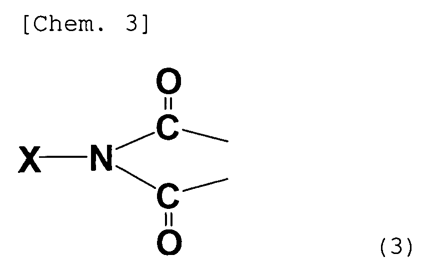

wherein X is a monovalent organic group, more preferably a monovalent aromatic group.

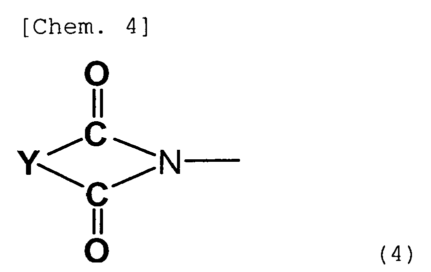

wherein Y is a divalent organic group, more preferably, a divalent aromatic group or a group having a C-C double bond.

Another preferred example of the organic-solvent-soluble polyimide (a) used in the present invention is a polymer having a structure represented by either of the following general formulas (5) and (6), at least one functional group reactable with an epoxy group in its side chain, and a structure represented by the above general formula (1) as R⁴ in the general formulas (5) and (6) in an amount of 5 to 15 wt% with respect to the total amount of the polymer.

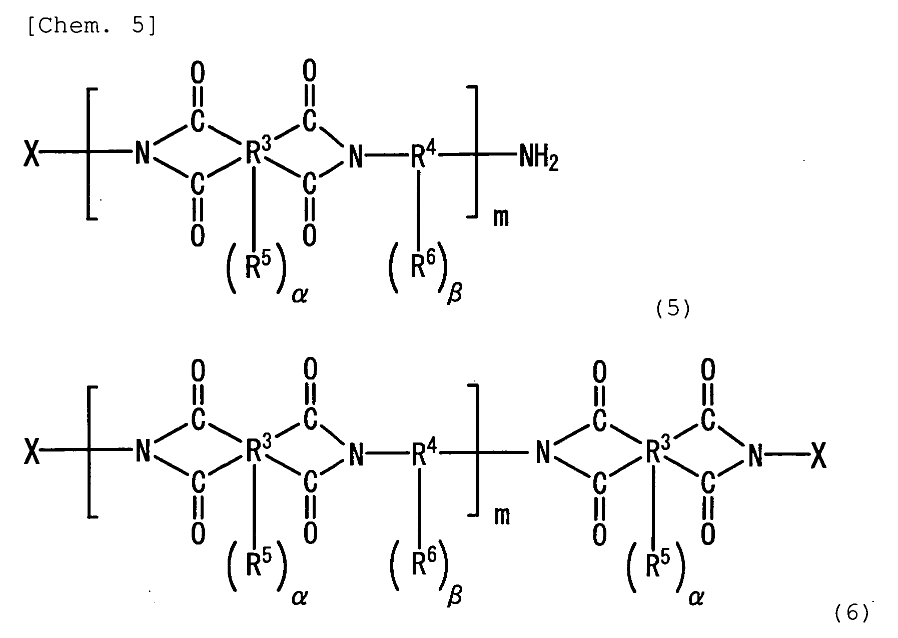

wherein R³ is a 4- to 14-valent organic group, R⁴ is a 2- to 12-valent organic group, at least one of R³ and R⁴ is an aromatic group containing at least one group selected from the group consisting of a 1,1,1,3,3,3-hexafluoropropyl group, an isopropyl group, an ether group, a thioether group, and a SO₂ group (hereinafter, referred to as a "specific group"), R⁵ and R⁶ are each a group selected from the group consisting of a phenolic hydroxyl group, a sulfonic acid group, and a thiol group, R³s, R⁴s, R⁵s, and R⁶s contained in one molecule of the organic-solvent-soluble polyimide may be different, R³s, R⁴s, R⁵s, and R⁶s contained in different molecules of the organic-solvent-soluble polyimide may be different, X is a monovalent organic group, m is 8 to 200, α and β are each an integer of 0 to 10, and α+β is an integer of 0 to 10, and wherein α+β is 1 to 10 in 20 to 90% of repeating units whose number is represented by m.

In the general formulas (2), (5), and (6), R³ represents a structural component of an acid dianhydride and is preferably a 4- to 14-valent organic group having 5 to 40 carbon atoms, R⁴ represents a structural component of a diamine and is preferably a 2- to 12-valent organic group having 5 to 40 carbon atoms, and each of R³ and R⁴ preferably contains at least one specific group.

R⁵ is a substituent of the acid dianhydride, and is selected from the group consisting of a phenolic hydroxyl group, a sulfonic acid group, and a thiol group, and R⁶ is a substituent of the diamine, and is selected from the group consisting of a phenolic hydroxyl group, a sulfonic acid group, and a thiol group.

An acid dianhydride to be used will be described. Specific examples of the acid dianhydride having at least one specific group include 2,2-bis(3,4-dicarboxyphenyl)propane dianhydride, 2,2-bis(2,3-dicarboxyphenyl)propane dianhydride, bis(3,4-dicarboxyphenyl)sulfonic dianhydride, bis(3,4-dicarboxyphenyl)ether dianhydride, 2,2-bis(3,4-dicarboxyphenyl)hexafluoropropane dianhydride, and compounds obtained by substituting hydrogen atoms on the aromatic rings of the above-mentioned compounds aromatic rings with alkyl groups or halogen atoms.

A specific example of the acid dianhydride having at least one specific group and at least one group selected from the group consisting of a phenolic hydroxyl group, a sulfonic acid group, and a thiol group is an aromatic acid dianhydride having the following structure:

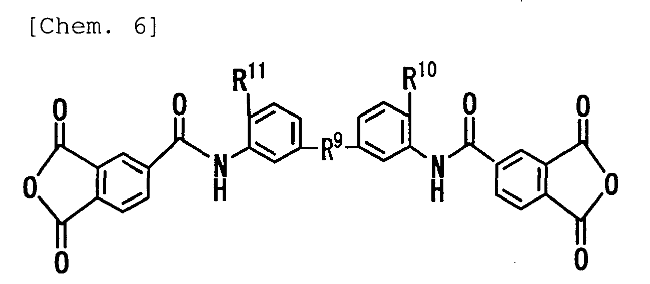

wherein R⁹ represents C(CF₃)₂, C(CH₃)₂, SO₂, S or O and R¹⁰ and R¹¹ are each a hydrogen atom, a hydroxyl group, a thiol group, or a sulfonic acid group, provided that R¹⁰ and R¹¹ are not hydrogen at the same time.

A specific example of the acid dianhydride having no specific group but having at least one group selected from the group consisting of a phenolic hydroxyl group, a sulfonic acid group, and a thiol group is an aromatic acid dianhydride having the following structure: 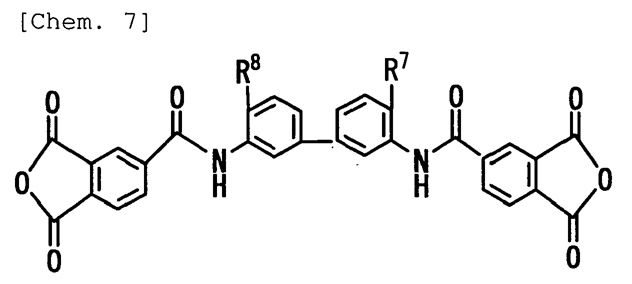 wherein R⁷ and R⁸ are each a hydrogen atom, a hydroxyl group, a thiol group, or a sulfonic acid group, provided that R⁷ and R⁸ are not hydrogen at the same time.

Specific examples of the acid dianhydride having neither a specific group nor a group selected from among a phenolic hydroxyl group, a sulfonic acid group, and a thiol group include aromatic tetracarboxylic dianhydrides such as pyromellitic dianhydride, 3,3',4,4'-biphenyltetracarboxylic dianhydride, 2,3,3',4'-biphenyltetracarboxylic dianhydride, 2,2',3,3'-biphenyltetracarboxylic dianhydride, 3,3',4,4'-benzophenonetetracarboxylic dianhydride, 2,2',3,3'-benzophenonetetracarboxylic dianhydride, 1,1-bis(3,4-dicarboxyphenyl)ethane dianhydride, 1,1-bis(2,3-dicarboxyphenyl)ethane dianhydride, bis(3,4-dicarboxyphenyl)methane dianhydride, bis(2,3-dicarboxyphenyl)methane dianhydride, 1,2,5,6-naphthalenetetracarboxylic dianhydride, 2,3,6,7-naphthalenetetracarboxylic dianhydride, 2,3,5,6-pyridinetetracarboxylic dianhydride, and 3,4,9,10-perylenetetracarboxylic dianhydride, and compounds obtained by substituting hydrogen atoms on the aromatic rings of the above-mentioned compounds with alkyl groups or halogen atoms.

In the present invention, these acid dianhydrides may be used singly or in combination of two or more of them.

A diamine to be used will be described. Specific examples of the diamine having at least one specific group include 3,4'-diaminodiphenyl sulfide, 4,4'-diaminodiphenyl sulfide, 3,4'-diaminodiphenyl ether, 4,4'-diaminodiphenyl ether, 3,4'-diaminodiphenyl sulfone, 4,4'-diaminodiphenyl sulfone, bis(4-aminophenoxyphenyl)sulfone, bis(3-aminophenoxyphenyl)sulfone, bis(4-aminophenoxy)biphenyl, bis{4-(4-aminophenoxy)phenyl}ether, 1,4-bis(4-aminophenoxy)benzene, 1,3-bis(4-aminophenoxy)benzene, 2,2-bis[4-(4-aminophenoxy)phenyl]hexafluoropropane, and 2,2-bis[4-(4-aminophenoxy)phenyl]propane, and compounds obtained by substituting hydrogen atoms on the aromatic rings of the above-mentioned compounds with alkyl groups or halogen atoms.

Specific examples of the diamine having at least one specific group and at least one group selected from the group consisting of a phenolic hydroxyl group, a sulfonic acid group, and a thiol group include: 2,2-bis(3-amino-4-hydroxyphenyl)hexafluoropropane, 2,2-bis(3-hydroxy-4-aminophenyl)hexafluoropropane, 2,2-bis(3-amino-4-hydroxyphenyl)propane, 2,2-bis(3-hydroxy-4-aminophenyl)propane, 3,3'-diamino-4,4'-dihydroxydiphenyl ether, 3,3'-diamino-4,4'-dihydroxydiphenylsulfone, 3,3'-diamino-4,4'-dihydroxydiphenylsulfide, compounds obtained by substituting hydrogen atoms on the aromatic rings of the above-mentioned compounds with alkyl groups or halogen atoms, and diamines having the following structures: 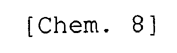 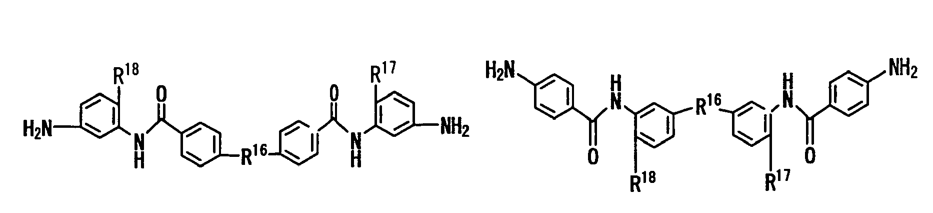 wherein R¹⁶ represents C(CF₃)₂, C(CH₃)₂, SO₂, S or O, R¹⁷ and R¹⁸ are each a hydrogen atom, a hydroxyl group, a thiol group, or a sulfonic acid group, provided that R¹⁷ and R¹⁸ are not hydrogen at the same time.

Specific examples of the diamine having no specific group but having at least one group selected from the group consisting of a phenolic hydroxyl group, a sulfonic acid group, and a thiol group include 3,3'-diamino-4,4'-dihydroxybiphenyl, 2,4-diamino-phenol, 2,5-diaminophenol, 1,4-diamino-2,5-dihydroxybenzene, diaminodihydroxypyrimidine, diaminodihydroxypyridine, hydroxydiaminopyrimidine, 9,9-bis(3-amino-4-hydroxyphenyl)fluorene, compounds obtained by substituting hydrogen atoms on the aromatic rings of the above-mentioned compounds with alkyl groups or halogen atoms, and diamines having the following structures: 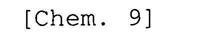 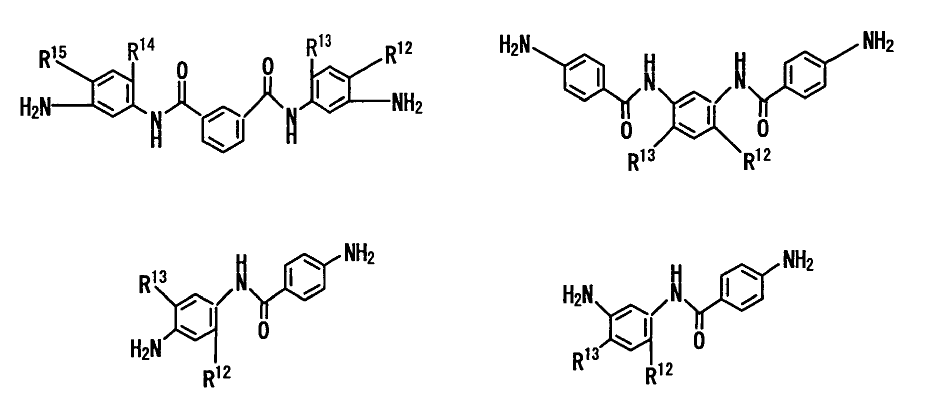 wherein R¹² to R¹⁵ are each a hydrogen atom, a hydroxyl group, a thiol group, or a sulfonic acid group, provided that R¹² and R¹³ are not hydrogen at the same time.

Specific examples of the diamine having neither a specific group nor a group selected from among a phenolic hydroxyl group, a sulfonic acid group, and a thiol group include 3,4'-diaminodiphenylmethane, 4,4'-diaminodiphenylmethane, benzidine, m-phenylenediamine, p-phenylenediamine, 1,5-naphthalenediamine, 2,6-naphthalenediamine, 2,2'-dimethyl-4,4'-diaminobiphenyl, 2,2'-diethyl-4,4'-diaminobiphenyl, 3,3'-dimethyl-4,4'-diaminobiphenyl, 3,3'-diethyl-4,4'-diaminobiphenyl, 2,2'3,3'-tetramethyl-4,4'-diaminobiphenyl, 3,3',4,4'-tetramethyl-4,4'-diaminobiphenyl, 2,2'-di(trifluoromethyl)-4,4'-diaminobiphenyl, compounds obtained by substituting hydrogen atoms on the aromatic rings of the above-mentioned compounds with alkyl groups or halogen atoms, terephthalic hydrazide, isophthalic hydrazide, phthalic hydrazide, 2,6-naphthalenedicarboxylic dihydrazide, 4,4'-bisphenyl dicarbonohydrazine, 4,4'-cyclohexane dicarbonohydrazine, and hydrazide compounds obtained by substituting hydrogen atoms on the aromatic rings of the above-mentioned compounds with alkyl groups or halogen atoms. These diamines used in the present invention may be used singly or in combination of two or more of them.

A structure represented by the general formula (1) is contained as R⁴ in the general formulas (2), (5), and (6), and is therefore a moiety of a diamine. Examples of the diamine containing a structure represented by the general formula (1) include bis(3-aminopropyl)tetramethyldisiloxane and bis(p-amino-phenyl)octamethylpentasiloxane.

The cross-linking density of the adhesive composition can be adjusted by controlling the rate of the reaction between the polyimide and the epoxy compound during heat treatment by appropriately selecting R⁵ and R⁶ in the general formulas (2), (5), and (6). This makes it possible to impart necessary heat resistance and chemical resistance to the adhesive composition. In this regard, 20 to 90% of the total of R⁵s and R⁶s are preferably phenolic hydroxyl groups, sulfonic acid groups, or thiol groups. By setting the ratio of these groups to the total of R⁵s and R⁶s to 20% or more, it is possible to improve chemical resistance and heat resistance, and by setting the ratio to 90% or less, it is possible to suppress the cross-linking density within an appropriate range to maintain the elongation and toughness of film.

X as a structural component of the general formulas (3), (5), and (6) is a component derived from a primary monoamine that is an end capping agent, and may be either a single end capping group or a combination of two or more end capping groups. The primary monoamine is preferably an aromatic amine, and specific examples thereof include 5-aminoquinoline, 4-aminoquinoline, 3-aminonaphthalene, 2-aminonaphthalene, 1-aminonaphthalene, and aniline. Among them, aniline is preferably used.

As the primary monoamine, one not having another substituent that reacts with the epoxy compound is preferably used. This makes it possible to obtain an organic-solvent-soluble polyimide not having a substituent that reacts with the epoxy compound at the end of the polyimide having high molecular mobility. The use of such an organic-solvent-soluble polyimide makes it possible to suppress the progress of the reaction between the organic-solvent-soluble polyimide and the epoxy compound at room temperature, thereby further improving the storage stability of the adhesive composition.

When determined in terms of the primary monoamine component of the end capping agent as a starting component for the formation of the X component, the ratio of the X component shown in the general formulas (3), (5), and (6) to be introduced is preferably 0.1 to 60 mol%, particularly preferably 5 to 50 mol% with respect to the total diamine component.

Y in the general formula (4) is derived from a dicarboxylic anhydride that is an end capping agent. The acid anhydride to be used as an end capping agent is preferably an aromatic dicarboxylic acid or a dicarboxylic acid having a C-C double bond. Preferred specific examples thereof include phthalic anhydride, 1,8-naphthalenedicarboxylic anhydride, succinic anhydride, and maleic anhydride. These acid anhydrides may be used singly or in combination of two or more of them.

In the general formulas (5) and (6), m represents the repeating number of the polymer, and is 8 or more but 200 or less, preferably 10 to 150. The polystyrene equivalent weight-average molecular weight of the organic-solvent-soluble polyimide as measured by gel filtration chromatography is preferably 4,000 to 80,000, particularly preferably 8,000 to 60,000. By setting m to 8 or more, it is possible to increase the viscosity of the adhesive composition to achieve a thick coating, and by setting m to 200 or less, it is possible to improve the solubility of the adhesive composition in a solvent. Here, the weight-average molecular weight of the organic-solvent-soluble polyimide (a) can be determined in the following manner. A polyimide solution having a solid concentration of 0.1 wt% is prepared by dissolving the soluble polyimide in N-methylpyrrolidone (NMP), and the polystyrene equivalent weight-average molecular weight of the soluble polyimide is calculated using the polyimide solution and a GPC apparatus Waters 2690 (manufactured by Waters Corporation). GPC measurement is performed using NMP containing 0.05 mol/L of LiCl and 0. 05 mol/L of phosphoric acid dissolved therein as a mobile phase at a developing speed of 0.4mL/min. A GPC measurement system used includes, for example, the following.
Detector: Waters 996
System controller: Waters 2690
Column oven: Waters HTR-B
Thermo controller: Waters TCM
Columns: TOSOH grard comn, TOSOH TSK-GEL α-4000, TOSOH TSK-GEL α-2500

The polyimide having a structural unit represented by the general formula (2), at least one functional group reactable with an epoxy group in its side chain, a structure(s) represented by the general formula (3) and/or the general formula (4) at least one of the ends of its main chain, and a structure represented by the general formula (1) as R⁴ in the general formula (2) in an amount of 5 to 15 wt% with respect to the total amount of the polymer may be a polymer composed of only a structural unit represented by the general formula (2), a copolymer having another structure as a copolymerization component in addition to a structural unit represented by the general formula (2), or a mixture thereof. The copolymer may contain a precursor of a structural unit represented by the general formula (2) (polyamic acid structure). Further, any one of them may be mixed with a polyimide represented by another structure. In this case, a structural unit represented by the general formula (2) is preferably contained in an amount of 50 mol% or more. The type and amount of the structure used for copolymerization or mixing are preferably selected without impairing the heat resistance of a heat resistant resin coating obtained by heat treatment.

The polyimide having a structure represented by either of the general formula (5) or (6), at least one functional group reactable with an epoxy group in its side chain, and a structure represented by the general formula (1) as R⁴ in the general formulas (5) and (6) in an amount of 5 to 15 wt% with respect to the total amount of the polymer may be a polymer composed of only a structure represented by the general formula (5) or (6), a copolymer having another structure as a copolymerization component in a structure represented by the general formula (5) or (6), or a mixture thereof. Further, any one of them may be mixed with a polyimide represented by another structure. In this case, a structure represented by the general formula (5) or (6) is preferably contained in an amount of 50 mol% or more. The type and amount of the structure used for copolymerization or mixing are preferably selected without impairing the heat resistance of a heat resistant resin coating obtained by heat treatment.

It is to be noted that the solubility of the organic-solvent-soluble polyimide (a) used in the present invention refers to the ability to be dissolved in at least one solvent selected from the following solvents in an amount of 20 wt% or more at 23°C: ketone-based solvents such as acetone, methyl ethyl ketone, methyl isobutyl ketone, cyclopentanone, and cyclohexanone; ether-based solvents such as 1,4-dioxane, tetrahydrofuran, and diglyme; glycol ether-based solvents such as methyl cellosolve, ethyl cellosolve, propylene glycol monomethyl ether, propylene glycol monoethyl ether, propylene glycol monobutyl ether, and diethylene glycol methyl ethyl ether; and other solvents such as benzyl alcohol, N-methylpyrrolidone, γ-butyrolactone, ethyl acetate, and N,N-dimethylformamide.

The organic-solvent-soluble polyimide (a) used in the present invention is synthesized by a well-known method by substituting part of a diamine with an end capping agent that is a monoamine or by substituting part of an acid dianhydride with an end capping agent that is a monocarboxylic acid, an acid anhydride, a monoacid chloride compound, or a monoactive ester compound. For example, a polyimide precursor is obtained by a method in which a tetracarboxylic dianhydride is reacted with a diamine compound (part of which is substituted with an end capping agent that is a monoamine) at a low temperature, a method in which a tetracarboxylic dianhydride (part of which is substituted with an end capping agent that is an acid anhydride, a monoacid chloride compound, or a monoactive ester compound) is reacted with a diamine compound at a low temperature, a method in which a diester is obtained by the reaction between a tetracarboxylic dianhydride and an alcohol and is then reacted with a diamine (part of which is substituted with an end capping agent that is a monoamine) in the presence of a condensing agent, or a method in which a diester is obtained by the reaction between a tetracarboxylic dianhydride and an alcohol and then the residual dicarboxylic acid is acid-chlorinated and reacted with a diamine (part of which is substituted with an end capping agent that is a monoamine), and is then subjected to an imidization reaction by a well-known method to synthesize an organic-solvent-soluble polyimide.

A structure represented by the general formula (1) introduced into the polymer and an end capping agent used in the present invention can be easily detected and quantitatively analyzed in the following manner. For example, a polymer into which a structure represented by the general formula (1) and an end capping agent have been introduced is dissolved in an acidic solution or a basic solution to decompose it into a diamine component and an acid anhydride component that are structural units of the polymer. The structure represented by the general formula (1) and the end capping agent used can be easily detected and quantitatively analyzed by subjecting the solution to gas chromatography (GC) or NMR measurement. Alternatively, a polyimide into which an end capping agent has been introduced may be directly subjected to pyrolysis gas chromatography (PGC) or infrared spectral measurement and ¹³CNMR spectral measurement. Also in this case, the structure represented by the general formula (1) and the end capping agent used can be easily detected and quantitatively analyzed.

The imidization ratio of the organic-solvent-soluble polyimide (a) can be easily determined by, for example, the following method. As used herein, the imidization ratio means how much mol% of a polyimide precursor is converted into a polyimide when the polyimide is synthesized via the polyimide precursor in such a manner as described above. First, the infrared absorption spectrum of a polymer is measured to confirm the presence of the absorption peaks (at about 1780 cm⁻¹ and about 1377 cm⁻¹) of an imide structure derived from a polyimide. Then, the polymer is heat-treated at 350°C for 1 hour, and the infrared absorption spectrum of the polymer is again measured to compare a peak intensity at about 1377 cm⁻¹ measured before heat treatment with that measured after heat treatment. Assuming that the imidization ratio of the polymer after heat treatment is 100%, the imidization ratio of the polymer before heat treatment is determined. The imidization ratio of the polymer is preferably 90% or higher.

The organic-solvent-soluble polyimide (a) content is 15 to 90 parts by weight with respect to 100 parts by weight of the epoxy compound (b), and is preferably 30 to 70 parts by weight from the viewpoint of the reaction with the epoxy compound to form a high-density network structure. If the organic-solvent-soluble polyimide (a) content is less than 15 parts by weight, heat resistance is lowered. On the other hand, if the organic-solvent-soluble polyimide (a) content exceeds 90 parts by weight, the adhesive composition is likely to absorb water, and is therefore foamed when hardened by heating, which reduces the adhesive force between adherends (e.g., between a circuit board and a semiconductor chip) and lowers connection reliability.

The adhesive composition according to the present invention further contains the epoxy compound (b). The epoxy compound (b) reacts with a phenolic hydroxyl group, a sulfonic acid group, and/or a thiol group in the polyimide side chain to form a hardened article having a high-density network structure, and therefore the resulting hardened adhesive composition exhibits resistance to various chemicals. The hardened adhesive composition exhibits high resistance to various solvents, especially to N-methylpyrrolidone. The epoxy compound is generally hardened by a ring-opening reaction accompanied by no shrinkage, which makes it possible to reduce the shrinkage of the adhesive composition during hardening. As the epoxy compound (b), an epoxy compound having two or more epoxy groups or an epoxy compound having an epoxy equivalent of 100 to 500 is preferably used. By setting the epoxy equivalent to 100 or more, it is possible to increase the toughness of the hardened adhesive composition, and by setting the epoxy equivalent to 500 or less, it is possible to allow the hardened adhesive composition to have a high-density network structure and excellent electrical insulation properties.

The epoxy compound (b) contains two kinds of epoxy compounds, or a liquid epoxy compound and a solid epoxy compound. The liquid epoxy compound content is preferably 20 wt% or more but 60 wt% or less, more preferably 30 wt% or more but 50 wt% or less with respect to the total amount of the epoxy compound. By setting the liquid epoxy compound content to a value within the above range, it is possible to impart appropriate plasticity and flexibility to the adhesive composition.

As used herein, the liquid epoxy compound refers to one having a viscosity of 150 Pa·s or less at a temperature of 25°C and a pressure of 1.013 × 10⁵ N/m², and the solid epoxy compound refers to one having a viscosity exceeding 150 Pa·s at a temperature of 25°C and a pressure of 1.013 × 10⁵ N/m². Examples of the liquid epoxy compound include, but are not limited to, JER 828, JER 1750, JER 152, and JER 630 (trade names, manufactured by Mitsubishi Chemical Corporation) and Epiclon HP-4032 (trade name, manufactured by DIC CORPORATION). These liquid epoxy compounds may be used in combination of two or more of them. Examples of the solid epoxy compound include, but are not limited to, JER 1002, JER 1001, YX4000H, JER 4004P, JER 5050, JER 154, JER 157S70, JER 180S70, YX 4000H, and YL 980 (trade names, manufactured by Mitsubishi Chemical Corporation), TEPIC S, TEPIC G, and TEPIC P (trade names, manufactured by NISSAN CHEMICAL INDUSTRIES, LTD.), EPOTOTE YH-434L (trade name, manufactured by Nippon Steel Chemical Co. , Ltd.), EPPN 502H and NC3000 (trade names, manufactured by Nippon Kayaku Co., Ltd.), and EPICLON N695 and EPICLON HP-7200 (trade names, manufactured by DIC CORPORATION). These solid epoxy compounds may be used in combination of two or more of them.

The adhesive composition according to the present invention contains the hardening accelerator particles (c). By allowing a hardening accelerator to be present in the form of particles in the adhesive composition, it is possible to retard the hardening reaction of the epoxy compound, thereby improving the storage stability of the adhesive composition at room temperature.

The hardening accelerator particle (c) content is 0.1 part by weight or more but 50 parts by weight or less with respect to 100 parts by weight of the epoxy compound (b). By setting the hardening accelerator particle (c) content to a value within the above range, it is possible to store the adhesive composition over a long time at room temperature and therefore to harden the adhesive composition sufficiently. Further, by setting the hardening accelerator particle content to a value within the above range, it is possible to well mix the hardening accelerator particles with inorganic particles (which will be described later) and therefore to uniformly harden the adhesive composition. This makes it possible to improve the connection reliability of a semiconductor device produced using the resulting adhesive composition. The hardening accelerator particle (c) content is particularly preferably 20 parts by weight or more with respect to 100 parts by weight of the epoxy compound (b), which makes it possible to harden the adhesive composition in a short period of time even at a low temperature. The hardening temperature and time are, for example, 160°C to 200°C and 5 seconds to 20 minutes, respectively, but are not limited thereto. If the hardening accelerator particle (c) content is less than 0.1 part by weight with respect to 100 parts by weight of the epoxy compound (b), the adhesive composition is not sufficiently hardened. In this case, there is a possibility that the connection reliability of a semiconductor device produced using the resulting adhesive composition is lowered. On the other hand, if the hardening accelerator particle (c) content exceeds 50 parts by weight with respect to 100 parts by weight of the epoxy compound (b), hardening of the adhesive composition proceeds but the hardened adhesive composition has high moisture absorbency and, in addition, brittleness. Also in this case, the connection reliability of a semiconductor device produced using the resulting adhesive composition is lowered.

As the hardening accelerator particles, those insoluble in components contained in the adhesive composition are used. Imidazole-based hardening accelerator particles are preferably used as the hardening accelerator particles, because a structure in which the inorganic particles (d) are coordinated on the surface of the hardening accelerator particles is formed by interaction, and therefore an adhesive composition having excellent storage stability can be obtained. Preferred examples of such hardening accelerator particles (c) to be used include CUREZOL 2PZCNS, CUREZOL 2PZCNS-PW, CUREZOL C11Z-CNS, CUREZOL 2MZ-A, CUREZOL C11-A, CUREZOL 2E4MZ-A, CUREZOL 2MZA-PW, CUREZOL 2MAOK-PW, and CUREZOL 2PHZ-PW (trade names, manufactured by SHIKOKU CHEMICALS CORPORATION).

By using a microcapsule-type hardening accelerator, it is possible to further improve storage stability. Preferred examples of such a microcapsule-type hardening accelerator to be used include NOVACURE HX-3941HP, NOVACURE HXA3922HP, NOVACURE HXA3932HP, and NOVACURE HXA3042HP (trade names, manufactured by ASAHI KASEI E-MATERIALS CORPORATION) that are microcapsule-type hardening accelerators obtained by treating amine adduct-type hardening accelerators with isocyanates.

As the microcapsule-type hardening accelerator, one that is present in a state where it is dispersed in a liquid epoxy compound is preferably used. In this case, the weight ratio between the microcapsule-type hardening accelerator and the liquid epoxy resin is 100 parts by weight or more but 500 parts by weight or less of the epoxy compound to 100 parts by weight of the microcapsule-type hardening accelerator. For example, in the case of NOVACURE (trade name, manufactured by ASAHI KASEI E-CHEMIALS CORPORATION) series, 200 parts by weight of a liquid epoxy compound is contained per 100 parts by weight of a microcapsule-type hardening accelerator. Therefore, when NOVACURE (trade name, manufactured by ASAHI KASEI E-CHEMIALS CORPORATION) series is used as the microcapsule-type hardening accelerator, the epoxy compound contained in the adhesive composition also includes a liquid epoxy compound contained in the microcapsule-type hardening accelerator. In this case, the amount of the liquid epoxy compound contained in the microcapsule-type hardening accelerator is included in the amount of the epoxy compound (b) when the amount of each component contained in the adhesive composition is calculated. Therefore, the amount of the hardening accelerator particles (c) is determined by subtracting the weight of the liquid epoxy compound contained in the microcapsule-type hardening accelerator from the total weight of the microcapsule-type hardening accelerator.

The average particle size of the hardening accelerator particles (c) is preferably 0.5 to 5 µm. As used herein, the average particle size refers to the most frequently observed size of the individual hardening accelerator particles. When the hardening accelerator particles have a spherical form, the "size" refers to its diameter, and when the hardening accelerator particles have an oval or flat form, the "size" refers to its maximum length. Further, when the hardening accelerator particles have a rod or fibrous form, the "size" refers to its maximum longitudinal length. In the case of the microcapsule-type hardening accelerator, its particle size includes the thickness of a capsule.

The transparency of the adhesive composition can be improved by reducing the difference between the refractive index of a medium comprising the organic-solvent-soluble polyimide (a), the epoxy compound (b), and other constituent materials and the refractive index of the hardening accelerator particles (c).

Another hardening accelerator may be used together with the hardening accelerator particles (c). Specific examples of such another hardening accelerator include amine-based hardening accelerators, phosphine-based hardening accelerators, phosphonium-based hardening accelerators, sulfonium-based hardening accelerators, and iodonium-based hardening accelerators.

The adhesive composition according to the present invention contains the inorganic particles (d). The use of the inorganic particles makes it possible to adjust the melt viscosity of the adhesive composition so as not to cause foaming when the adhesive composition is hardened by heating. Examples of the material of the inorganic particles include silica, alumina, titania, silicon nitride, boron nitride, aluminum nitride, iron oxide, glass, other metal oxides, metal nitrides, metal carbonates, and metal sulfates such as barium sulfate. These materials may be used singly or in combination of two or more of them. Among them, silica is preferably used from the viewpoint of low thermal expansibility, thermal dissipation performance, low moisture absorptivity, and dispersion stability in the adhesive composition.

The inorganic particle (d) content is 30 to 80 wt%, preferably 30 to 70 wt%, more preferably 35 to 60 wt%, even more preferably 35 to 50 wt% with respect to the total amount of the above-described components (a) to (d) of the adhesive composition and other components, other than solvents, added if necessary. If the inorganic particle (d) content is less than 30 wt%, the adhesive composition is foamed when hardened by heating, which lowers the connection reliability of a semiconductor device produced using the resulting adhesive composition. Particularly, it is difficult for the semiconductor device to maintain connection reliability when the semiconductor device is subjected to a process where higher durability is required such as a moisture absorption-reflow process or a thermal cycle process. On the other hand, if the inorganic particle (d) content exceeds 80 wt%, the following three problems (A) to (C) occur: (A) the dispersibility of the inorganic particles in the adhesive composition is poor so that the agglomeration of the inorganic particles occurs; (B) the inorganic particles are not uniformly mixed with the hardening accelerator particles so that the connection reliability of a semiconductor device produced using the resulting adhesive composition is lowered; and (C) when the adhesive composition is applied onto a release plastic film to form an adhesive sheet and the adhesive sheet is wound into a roll, cracks are produced in the adhesive sheet or the adhesive sheet is separated from the release plastic film.

Further, when the adhesive composition whose inorganic particle (d) content is 30 to 80 wt% is used, no trace of suction is left on the surface of the adhesive composition even when a semiconductor chip with the adhesive composition is transferred using a vacuum suction collet of a mounting machine. Further, wicking of the adhesive composition onto the side surface of the semiconductor chip can be suppressed when the semiconductor chip is mounted on a circuit board. This makes it possible to mount the semiconductor chip without adhesion of the adhesive composition to the rear surface of the semiconductor chip and a heating tool of the mounting machine even when the thickness of the semiconductor chip is 100 µm or less due to, for example, backgrinding of a semiconductor wafer.

The inorganic particles (d) may have either a spherical form or a nonspherical form such as a crushed form or a flake form, but preferably have a spherical form from the viewpoint of uniform dispersibility in the adhesive composition. Further, the average particle size of the spherical inorganic particles is preferably 3 µm or less, more preferably 10 nm or more but 1 µm or less. If the average particle size is less than 10 nm, the inorganic particles are poor in dispersibility, which makes it impossible to allow the inorganic particles to be contained in the adhesive composition in a high concentration. In this case, there is a possibility that the coordination number of the inorganic particles on the surface of the hardening accelerator particle (c) is reduced, thereby reducing the effect of improving storage stability. On the other hand, if the average particle size exceeds 3 µm, there is a case where the coordination number of the inorganic particles around the hardening accelerator particle (c) or the microcapsule-type hardening accelerator is reduced, thereby reducing the effect of improving storage stability.

When the adhesive composition needs to have transparency, the particle size of the inorganic particles is preferably 100 nm or less, more preferably 60 nm or less. For example, the adhesive composition needs to have transparency when, after a film of the adhesive composition is formed on a substrate, it is necessary to visually identify marks on the surface of the substrate through the adhesive composition for the purpose of alignment and the like.

It is to be noted that the average particle size of the inorganic particles refers to the most frequently observed size of the individual inorganic particles. When the inorganic particles have a spherical form, the "size" refers to its diameter, and when the inorganic particles have an oval or flat form, the "size" refers to its maximum length. Further, when the inorganic particles have a rod or fibrous form, the "size" refers to its maximum longitudinal length. As a method for measuring the average particle size of the inorganic particles contained in the adhesive composition, a SEM (scanning electron microscope) can be used for directly observing the particles and determining the average of particle sizes of 100 particles by calculation.

The content ratio of the inorganic particles (d) to the hardening accelerator particles (c) (i.e., (d)/(c)) is preferably larger than 2.0 but 4,000 or less, more preferably 2.5 or more but 15 or less. If the content ratio (d)/(c) is 2. 0 or less, the coordination number of the inorganic particles around the hardening accelerator particle is reduced, which makes it impossible to improve storage stability. If the content ratio (d)/(c) exceeds 4,000, the ability of the hardening accelerator particles or the microcapsule-type hardening accelerator to accelerate hardening is lowered, which makes it difficult to harden the adhesive composition at a low temperature in a short period of time.

For the purpose of reducing the stress of a film obtained by hardening the adhesive composition, the adhesive composition according to the present invention may contain a thermoplastic resin. Examples of the thermoplastic resin include, but are not limited to, phenoxy resins, polyesters, polyurethanes, polyamides, polypropylene, acrylonitrile-butadiene copolymer (NBR), styrene-butadiene copolymer, (SBR), acrylonitrile-butadiene-methacrylic acid copolymer, and acrylonitrile-butadiene-acrylic acid copolymer.

The adhesive composition according to the present invention may contain a corrosion suppressor for suppressing the corrosion of circuit material metals or an electromigration phenomenon, an antioxidant, and/or an ion scavenger without impairing the properties of the adhesive.

The antioxidant is not particularly limited as long as it can impart antioxidant function, and examples thereof include well-known antioxidants such as phenol-based antioxidants, thioether-based antioxidants, phosphorus-based antioxidants, and amine-based antioxidants.

As the ion scavenger, an inorganic ion exchanger is frequently used. An inorganic ion exchanger is effective at scavenging ionic impurities for the following reasons (i) to (iv), and is therefore expected to suppress a reduction in insulating resistance and prevent the corrosion of aluminum wiring and the occurrence of ion migration: (i) its ion selectivity is high and therefore a specific ion can be separated from a system containing two or more kinds of ions; (ii) its heat resistance is excellent; (iii) stablility against organic solvents and resins is excellent; and (iv) its oxidation resistance is excellent. Examples of such an inorganic ion exchanger include: 1) aluminosilicates (e.g., natural zeolite, synthetic zeolite); 2) hydroxides or hydrous oxides (e.g., hydrous titanium oxide, hydrous bismuth oxide); 3) acid salts (e.g., zirconium phosphate, titanium phosphate); 4) basic salts and mixed hydrous oxides (e.g., hydrotalcites); 5) heteropolyacids (e.g., ammonium molybdophosphate); and 6) hexacyanoiron(III) salts (e.g., hexacyanozinc). The trade names of these inorganic ion exchangers are IXE-100, IXE-300, IXE-500, IXE-530, IXE-550, IXE-600, IXE-633, IXE-700, IXE-700F, IXE-800, IXE-6107, and IXE-6136 (manufactured by TOAGOSEI CO., LTD.) and DHT-4A, DHT-4A-2, Kyowaad 2100, and DHT-4H (manufactured by Kyowa Chemical Industry Co., Ltd.). The use of such an ion scavenger makes it possible to scavenge impurity ions inherently contained in the adhesive composition or impurity ions generated from an adherend including metallic parts such as electrodes after connection with the adherend. When the adherend is a mounting circuit board, examples of a possible impurity ion source include a solder resist, a glass epoxy substrate, and an adhesive used. Further, by allowing the ion exchanger to capture metal ions, it is possible to reduce the metal ion concentration of the adhesive composition to prevent electromigration. These components may be used singly or in combination of two or more of them. The ion scavenger content is preferably 1 to 10 parts by mass with respect to 100 parts by mass of the total mass of the adhesive composition from the viewpoint of effects obtained by adding the ion scavenger, heat resistance, and cost.

The adhesive composition according to the present invention may be used as a varnish obtained by mixing its constituents materials in a solvent or as a film obtained by applying it onto a release base material and removing the solvent. Examples of the solvent include, but are not limited to: ketone-based solvents such as acetone, methyl ethyl ketone, methyl isobutyl ketone, cyclopentanone, and cyclohexanone; ether-based solvents such as 1,4-dioxane, tetrahydrofurane, and diglyme; glycol ether-based solvents such as methyl cellosolve, ethyl cellosolve, propylene glycol monomethyl ether, propylene glycol monoethyl ether, propylene glycol monobutyl ether, and diethylene glycol methyl ethyl ether; and other solvents such as benzyl alcohol, N-methylpyrrolidone, γ-butyrolactone, ethyl acetate, and N,N-dimethylformamide. These solvents may be used singly or in combination of two or more of them.

Examples of the release base material include, but are not limited to, polypropylene film, polyethylene terephthalate film, polyethylene naphthalate film, polyester film, polyvinyl chloride film, polycarbonate film, polyimide film, fluoropolymer film such as polytetrafluoroethylene film, polyphenylene sulfide film, polypropylene film, and polyethylene film. The release base material may be subjected to release treatment using a releasing agent such as a silicone-based releasing agent, a long-chain alkyl-based releasing agent, a fluorine-based releasing agent, or an aliphatic amide-based releasing agent. The thickness of the release base material is not particularly limited, but is usually preferably 5 to 75 µm. The thickness of the release base material is preferably equal to or larger than that of the adhesive composition from the viewpoint of reducing residual stress in the adhesive composition. Further, another release base material is preferably laminated on the surface of the adhesive composition opposite to the surface having the release base material, that is, the adhesive composition is preferably sandwiched between two release base materials. As the another release base material, one made of the above-mentioned material and having a thickness within the above-mentioned range may be used. The two release base materials may be the same.

Further, it is preferred that there is a difference between the adhesive force between one of the release base materials and the adhesive composition and the adhesive force between the other release base material and the adhesive composition. The difference in adhesive force is preferably 5 N/m or more, more preferably 47 N/m or less. By setting the difference in adhesive force to 5 N/m or more, it is possible, when one of the release base materials whose adhesive force to the adhesive composition is smaller is peeled off, to prevent the adhesive composition from being totally or partially separated from the other release base material. Further, by setting the difference in adhesive force to 47 N/m or less, the adhesive composition is less likely to remain on the surface of each of the release base materials when the release base material is peeled off.

The minimum melt viscosity of the adhesive composition according to the present invention is preferably larger than 500 Pa·s but less than 10,000 Pa.s, more preferably 600 Pa·s or more but 5,000 Pa·s or less. By setting the minimum melt viscosity to a value within the above range, it is possible, when an adhesive sheet using the adhesive composition is laminated on a semiconductor wafer or a circuit board, to prevent the adhesive sheet from becoming wrinkled or to prevent air bubbles from being trapped between the adhesive sheet and the semiconductor wafer or the circuit board. In addition, it is also possible to reduce the amount of the adhesive composition squeezing out from the edges of a semiconductor chip during semiconductor chip bonding performed using the adhesive composition through the application of heat. It is to be noted that the minimum melt viscosity of the adhesive composition can be measured using, for example, a dynamic mechanical analyzer and a sample having a diameter of 15 mm and a thickness of 0.8 mm at a temperature rise rate of 2°C/min and a measuring frequency of 1 Hz within a temperature range of 0 to 150°C.

The adhesive composition according to the present invention is suitable for use as an adhesive for semiconductor for adhering, fixing, or sealing semiconductor chips, semiconductor devices, circuit boards, and metal wiring materials. In the present invention, the "semiconductor device" refers not only to one obtained by connecting a semiconductor element to a substrate or one obtained by connecting together semiconductor elements or substrates but also to all the devices that utilize semiconductor properties to function, and electrooptic devices, semiconductor circuit boards, and electronic parts comprising them are all included in the definition of "semiconductor device".

Hereinafter, a method for producing a semiconductor device using the adhesive composition according to the present invention will be described with reference to one example. A first circuit member having a first connection terminal and a second circuit member having a second connection terminal are placed so that the first connection terminal and the second connection terminal are opposed to each other. Then, the adhesive composition according to the present invention is interposed between the first circuit member and the second circuit member opposed to each other. The first and second connection terminals opposed to each other are electrically connected to each other through the application of heat and pressure. The electrical connection may be performed after the adhesive composition is applied onto only the connection terminal-side surface of one of the circuit members or after the adhesive composition is applied onto both the connection terminal-side surface of the first circuit member and the connection terminal-side surface of the second circuit member. A through-electrode may be formed in one or both of the first circuit member and the second circuit member, and a connection terminal may be formed on one or both of the surfaces of the member. As such a circuit member, a semiconductor chip having bumps formed thereon such as plated bumps or stud bumps, a chip component such as a resistor chip or a capacitor chip, a semiconductor chip having TSV (through-silicon via) electrodes, or a substrate such as a silicon interposer, a glass epoxy circuit board, or a film circuit board is used.

Further, the adhesive composition according to the present invention can also be used as an adhesive resin material for producing a die attach film, a dicing die attach film, a lead frame fixing tape, a solder resist, and the like or as an adhesive resin material for producing an adhesive for adhering radiator plates, reinforcing plates, shielding materials, and the like.

A method for producing a semiconductor device will be described in which a semiconductor chip having bumps and a circuit board having a wiring pattern or a semiconductor chip are electrically connected to each other using the adhesive composition for semiconductor according to the present invention interposed therebetween so that the gap between the semiconductor chip and the circuit board having a wiring pattern or the semiconductor chip is sealed with the adhesive composition for semiconductor. The semiconductor chip and the circuit board or the semiconductor chip are connected to each other using the adhesive composition for semiconductor interposed therebetween. At this time, the adhesive composition for semiconductor may be cut to have a predetermined size and then applied onto the wiring pattern surface of the circuit board having a wiring pattern or the bump-forming surface of the semiconductor chip. Alternatively, the adhesive composition for semiconductor may be applied onto the bump-forming surface of a semiconductor wafer and then divided into chips by dicing the semiconductor wafer to produce semiconductor chips having the adhesive composition for semiconductor applied thereon.

After the adhesive composition for semiconductor is applied onto the circuit board having a wiring pattern or the semiconductor chip, the semiconductor chip is mounted by a bonding machine. The mounting conditions are not particularly limited as long as good electrical connection can be achieved, but application of heat and pressure needs to be performed at a temperature 100°C or higher and a pressure of 1 mN/bump or larger for 0.1 second or longer to harden the adhesive composition for semiconductor. The bonding temperature is preferably 120°C or higher but 300°C or lower, more preferably 150°C or higher but 250°C or lower, the bonding pressure is preferably 5 mN/bump or larger but 50,000 mN/bump or less, more preferably 10 mN/bump or larger but 10,000 mN/bump or less, and the bonding time is preferably 1 second or longer but 60 seconds or shorter, more preferably 2 seconds or longer but 30 seconds or shorter. During bonding, the bumps on the semiconductor chip and the wiring pattern on the circuit board are brought into contact with each other and temporarily pressure-bonded together by applying heat and pressure for 0.1 second or longer at a temperature of 50°C or higher and a pressure of 1 mN/bump or larger, and are then finally bonded together under the above-mentioned conditions. If necessary, after the completion of bonding, the circuit board with the semiconductor chip may be heated at a temperature of 50°C or higher but 200°C or lower for 10 seconds or longer but 24 hours or shorter.

Due to recent significant progress of automation of processes for producing a semiconductor device, adhesive compositions for semiconductor and circuit boards or semiconductor chips having an adhesive composition for semiconductor applied thereonto are required to be able to be stored at room temperature for preferably 30 days or longer, more preferably 60 days or longer before hardening. The use of the adhesive composition according to the present invention makes it possible to obtain a semiconductor device that can be stored for 60 days or longer even at room temperature, causes no foaming during bonding, provides initial electrical continuity even by a brief application of heat and pressure, and has excellent connection reliability such that electrical continuity can be maintained even after a heat shock test performed between -40°C to 125°C after moisture absorption-reflow.

### EXAMPLES

Hereinafter, the present invention will be described with reference to the following examples, but is not limited to these examples. Adhesive compositions prepared in the examples were evaluated by the following methods.

### Synthesis Example 1

### Synthesis of Organic Solvent-Soluble Polyimide A

Under a dry nitrogen flow, 24.54 g (0.067 mol) of 2,2-bis(3-amino-4-hydroxyphenyl)hexafluoropropane (hereinafter, referred to as "BAHF"), 4.97 g (0.02 mol) of 1,3-bis(3-aminopropyl)tetramethyldisiloxane) (hereinafter, referred to as "SiDA"), and 1.86 g (0.02 mol) of aniline as an end capping agent were dissolved in 80 g of NMP. Then, 31.02 g (0.1 mol) of bis(3,4-dicarboxyphenyl)ether dianhydride (hereinafter, referred to as "ODPA") was added thereto together with 20 g of NMP, and they were reacted at 20°C for 1 hour and then stirred at 50°C for 4 hours. Then, 15 g of xylene was added, and the xylene and water were subjected to azeotropic distillation while being stirred at 180°C for 5 hours. After the completion of stirring, the solution was charged into 3 L of water to obtain a white precipitate of a polymer. The precipitate was collected by filtration, washed with water three times, and dried using a vacuum drier at 80°C for 20 hours. The infrared absorption spectrum of the obtained polymer solid was measured, and as a result, absorption peaks of an imide structure derived from a polyimide were detected at about 1780 cm⁻¹ and 1377 cm⁻¹. In this way, an organic-solvent-soluble polyimide A having a functional group reactable with an epoxy group and containing 7.5 wt% of a structure represented by the general formula (1) was obtained. When 6 g of tetrahydrofuran was added to 4 g of the organic-solvent-soluble polyimide A and stirred at 23°C, the organic-solvent-soluble polyimide A was dissolved.

### Synthesis Example 2

### Synthesis of Organic Solvent-Soluble Polyimide B

Under a dry nitrogen flow, 18.31 g (0.05 mol) of BAHF, 7.46 g (0.03 mol) of SiDA, and 3.72 g (0.04 mol) of aniline as an end capping agent were dissolved in 150 g of NMP. Then, 52 g (0.1 mol) of 2,2-bis(4-dicarboxyphenoxy)phenyl)propane dianhydride (hereinafter, referred to as "BSAA") was added thereto together with 30 g of NMP, and they were reacted at 20°C for 1 hour and then stirred at 50°C for 4 hours and then at 180°C for 5 hours. After the completion of stirring, the solution was charged into 3 L of water to obtain a white precipitate of a polymer. The precipitate was collected by filtration, washed with water three times, and dried using a vacuum drier at 80°C for 20 hours. The infrared absorption spectrum of the obtained polymer solid was measured, and as a result, absorption peaks of an imide structure derived from a polyimide were detected at about 1780 cm⁻¹ and 1377 cm⁻¹. In this way, an organic-solvent-soluble polyimide B having a functional group reactable with an epoxy group and containing 8.8 wt% of a structure represented by the general formula (1) was obtained. When 6 g of tetrahydrofuran was added to 4 g of the organic-solvent-soluble polyimide B and stirred at 23°C, the organic-solvent-soluble polyimide B was dissolved.

### Synthesis Example 3

### Synthesis of Organic Solvent-Soluble Polyimide C

Under a dry nitrogen flow, 14.65 g (0.04 mol) of BAHF and 9. 96 g (0.04 mol) of SiDA were dissolved in 130 g of NMP. Then, 44.42 g (0.1 mol) of 2,2-bis(3,4-dicarboxyphenyl)hexafluoropropane dianhydride (hereinafter, referred to as "6FDA") was added thereto together with 20 g of NMP, and they were stirred at 20°C for 1 hour and then at 50°C for 2 hours. Then, 3.72 g (0.04 mol) of aniline was added thereto as an end capping agent, and they were stirred at 50°C for 2 hours and then at 180°C for 5 hours. After the completion of stirring, the solution was charged into 3 L of water to obtain a white precipitate of a polymer. The precipitate was collected by filtration, washed with water three times, and dried using a vacuum drier at 80°C for 20 hours. The infrared absorption spectrum of the obtained polymer solid was measured, and as a result, absorption peaks of imide structures derived from a polyimide were detected at about 1780 cm⁻¹ and 1377 cm⁻¹. In this way, an organic-solvent-soluble polyimide C having a functional group reactable with an epoxy group and containing 12.6 wt% of a structure represented by the general formula (1) was obtained. When 6 g of tetrahydrofuran was added to 4 g of the organic-solvent-soluble polyimide C and stirred at 23°C, the organic-solvent-soluble polyimide C was dissolved.

### Synthesis Example 4

### Synthesis of Organic Solvent-Soluble Polyimide D

Under a dry nitrogen flow, 4.82 g (0.0165 mol) of 1,3-bis(3-aminophenoxy)benzene (hereinafter, referred to as "APB-N"), 3.08 g (0.011 mol) of 3,3'-diamino-4,4'-dihydroxydiphenylsulfone (hereinafter, referred to as "ABPS"), 4.97 g (0.02 mol) of SiDA, and 0.47 g (0.005 mol) of aniline as an end capping agent were dissolved in 130 g of NMP. Then, 26.02 g (0.05 mol) of 2,2-bis{4-(3,4-dicarboxyphenoxy)phenyl}propane dianhydride (hereinafter, referred to as "BSAA") was added thereto together with 20 g of NMP, and they were reacted at 25°C for 1 hour and then stirred at 50°C for 4 hours and then at 180°C for 5 hours. After the completion of stirring, the solution was charged into 3 L of water and filtered to collect a precipitate. The precipitate was washed with water three times and dried using a vacuum drier at 80°C for 20 hours. The infrared absorption spectrum of the obtained polymer solid was measured, and as a result, absorption peaks of an imide structure derived from a polyimide were detected at about 1780 cm⁻¹ and 1377 cm⁻¹. In this way, an organic-solvent-soluble polyimide D having a functional group reactable with an epoxy group and containing 11.6 wt% of a structure represented by the general formula (1) was obtained. When 6 g of tetrahydrofuran was added to 4 g of the organic-solvent-soluble polyimide D and stirred at 23°C, the organic-solvent-soluble polyimide D was dissolved.

### Synthesis Example 5

### Synthesis of Organic Solvent-Soluble Polyimide E

Under a dry nitrogen flow, 4.82 g (0.0165 mol) of 1,3-bis(3-aminophenoxy)benzene (hereinafter, referred to as "APB-N"), 3.08 g (0.011 mol) of 3,3'-diamino-4,4'-dihydroxydiphenylsulfone (hereinafter, referred to as "ABPS"), 4.97 g (0.02 mol) of SiDA, and 0.55 g (0.005 mol) of 3-aminophenol as an end capping agent were dissolved in 130 g of NMP. Then, 26.02 g (0.05 mol) of 2,2-bis{4-(3,4-dicarboxyphenoxy)phenyl}propane dianhydride (hereinafter, referred to as "BSAA") was added thereto together with 20 g of NMP, and they were reacted at 25°C for 1 hour and then stirred at 50°C for 4 hours and then at 180°C for 5 hours. After the completion of stirring, the solution was charged into 3 L of water and filtered to collect a precipitate. The precipitate was washed with water three times and dried using a vacuum drier at 80°C for 20 hours. The infrared absorption spectrum of the obtained polymer solid was measured, and as a result, absorption peaks of an imide structure derived from a polyimide were detected at about 1780 cm⁻¹ and 1377 cm⁻¹. In this way, an organic-solvent-soluble polyimide E having a functional group reactable with an epoxy group and containing 11.5 wt% of a structure represented by the general formula (1) was obtained. When 6 g of tetrahydrofuran was added to 4 g of the organic-solvent-soluble polyimide E and stirred at 23°C, the organic-solvent-soluble polyimide E was dissolved.

Other materials used in Examples and Comparative Examples are as follows.

(b) Epoxy Compound
   Solid Epoxy Compound
   157S70 (trade name, epoxy equivalent: 210 g/eq, manufactured by Mitsubishi Chemical Corporation)
   Liquid Epoxy Compound
   YL980 (trade name, epoxy equivalent: 185 g/eq, manufactured by Mitsubishi Chemical Corporation)
(c) Hardening Accelerator Particles
   CUREZOL 2MZA-PW (trade name, manufactured by SHIKOKU CHEMICALS CORPORATION, average particle size: 4 µm)
   Microcapsule-type Hardening Accelerator
   Liquid epoxy compound contained in NOVACURE HX-3792 (trade name, manufactured by ASAHI KASEI E-MATERIALS CORPORATION)
   NOVACURE HX-3792 contains a microcapsule-type hardening accelerator and a liquid epoxy compound in a ratio of 1:2, and the liquid epoxy compound contained in NOVACURE HX-3792 is a bisphenol A-type epoxy compound. In rows labeled "NOVACURE HX-3792" in Tables, values in parentheses represent the amount (parts by weight) of microcapsules.

Liquid epoxy compound contained in NOVACURE HXA-3941HP (trade name, manufactured by ASAHI KASEI E-MATERIALS CORPORATION)
Liquid epoxy compound contained in NOVACURE HXA-3932HP (trade name, manufactured by ASAHI KASEI E-MATERIALS CORPORATION)
NOVACURE HXA-3941HP contains a microcapsule-type hardening accelerator and a liquid epoxy compound in a ratio of 1:2, and the liquid epoxy compound contained in NOVACURE HXA-3941HP is a 1: 4 mixture of a bisphenol A-type epoxy compound and a bisphenol F-type epoxy compound. In rows labeled "NOVACURE HXA-3941HP" in Tables, values in parentheses represent the amount (parts by weight) of microcapsules.

(d) Inorganic Particles
   IPA-ST-S (trade name, manufactured by NISSAN CHEMICAL INDUSTRIES, LTD., spherical silica particles, average particle size: 9 nm, suspension of 25.5 wt% silica in isopropyl alcohol)

MIBK-ST (trade name, manufactured by NISSAN CHEMICAL INDUSTRIES, LTD., spherical silica particles, average particle size: 12 nm, suspension of 30 wt% silica in methyl isobutyl ketone)

SX009KJA (trade name, manufactured by Admatechs Co., Ltd., spherical silica particles, average particle size: 50 nm, suspension of 50 wt% silica in methyl isobutyl ketone)
SO-E1 (trade name, manufactured by Admatechs Co., Ltd., spherical silica particles, average particle size: 0.25 µm)

SO-E2 (trade name, manufactured by Admatechs Co., Ltd., spherical silica particles, average particle size: 0.5 µm)

SO-E3 (trade name, manufactured by Admatechs Co., Ltd., spherical silica particles, average particle size: 1.0 µm)

SO-E5 (trade name, manufactured by Admatechs Co., Ltd., spherical silica particles, average particle size: 2.0 µm)

UF-320 (trade name, manufactured by Tokuyama Corporation, spherical silica particles, average particle size: 3.5 µm)

(e) Solvent: methyl isobutyl ketone
   Another Hardening Agent
   CUREZOL 2PZ (trade name, manufactured by SHIKOKU CHEMICALS CORPORATION, dissolved in adhesive compositions and not present as particles)

### Examples 1 to 41 and Comparative Examples 1 to 38

Adhesive composition varnishes of Examples 1 to 41 and Comparative Examples 1 to 38 were prepared by mixing their components in compounding ratios shown in Tables 1 to 13 and dispersing the inorganic particles and the hardening accelerator particles with the use of a ball mill.

### (1) Method for Producing Adhesive Composition

Each of the thus prepared adhesive composition varnishes having the compounding ratios shown in Tables 1 to 13 was applied onto the untreated surface of a 60 µm-thick polypropylene film (trade name: TORAYFAN BO 2570A, one-side corona discharge treated film) as a release base material with the use of a slit die coater (coating machine), and was dried at 80°C for 10 minutes. After drying, on the thus obtained adhesive composition film having a thickness of 50 µm, a 10 µm-thick polypropylene film (trade name: TORAYFAN BO YK57, one-side corona discharge treated film) was laminated as another release base material in such a manner that its untreated surface was brought into contact with the adhesive composition. The adhesive film whose both surfaces were covered with the release base materials was wound around a paper core having an outer diameter of 9.6 cm into a roll shape in such a manner that the release base material 2570A was located inside to obtain a master roll of an adhesive composition sheet. Then, the master roll was slit into a width of 7.5 mm with the use of a film slitter and wound around reels having an outer diameter of 5.0 cm into a roll shape in such a manner that the release base material 2570A was located inside to obtain a tape roll having the adhesive composition whose both surfaces were covered with the release base materials. The thus obtained tape roll was divided into two groups depending on their storage conditions and evaluated. One was subjected to the following processes (2) to (4) just after production and the other was stored under conditions of 23°C and RH 55% before subjected to the following processes (2) to (4).

### (2) Tape Attachment Process

The adhesive composition of the tape roll having the adhesive composition whose both surfaces were covered with the release base materials and produced in the above (1) was applied onto a circuit board with the use of a tape bonding machine (manufactured by Toray Engineering Co., Ltd. under the trade name of DA 2000). First, the release base material YK57 was removed from the tape roll having the adhesive composition whose both surfaces were covered with the release base materials to expose the surface of the adhesive composition. Then, the surface of the adhesive composition, from which the release base material YK57 had been removed, was bonded at 80°C for 1 second to a circuit board (gold pad electrodes, a glass epoxy substrate with a circuit on which 300 7.5 mm-square semiconductor chips can be mounted) fixed on a stage, and then the release base material 2570A was removed. This tape attachment process was repeatedly performed to obtain a circuit board having 300 7.5 mm-square areas onto which the adhesive composition was applied.

### (3) Flip Chip Bonding and Display Test of Produced Liquid Crystal Panels

Semiconductor chips were flip-chip bonded to the circuit board with the adhesive composition for semiconductor prepared in the above (2). The connection of the semiconductor chips to the circuit board with the adhesive composition for semiconductor was performed using a flip chip bonding machine (manufactured by Toray Engineering Co., Ltd. under the trade name of FC-2000). The flip chip bonding was performed by fixing the circuit board with the adhesive composition to a bonding stage heated to 80°C, temporarily pressure-bonding the semiconductor chips under conditions of a temperature of 80°C, a pressure of 15 N/chip (with gold stud bump electrodes having an average height of 35 µm, 448 bumps/chip, pitch: 60 µm, peripheral arrangement, 7.5 mm-square chip), and a time of 5 seconds, and then finally pressure-bonding the semiconductor chips under conditions of a temperature of 200°C, a pressure of 200 N/chip, and a time of 10 seconds. The bonding was performed per chip and repeated until 300 semiconductor chips were bonded to all the 300 areas. It is to be noted that the time from the beginning to end of bonding was 90 minutes. After the completion of bonding, the circuit board was divided by a substrate cutting machine into 300 circuit boards with a semiconductor. Each of the thus prepared circuit boards with a semiconductor was incorporated into a liquid crystal substrate to produce a liquid crystal panel (semiconductor device), and the liquid crystal panel was subjected to a display test. When displaying images, the liquid crystal panel was evaluated as "acceptable", and when displaying no images due to poor connection between the chip and the circuit board, the liquid crystal panel was evaluated as "unacceptable". The display test was performed on all the 300 liquid crystal panels, and evaluation was performed according to the following criteria. The evaluation results are shown in Tables 1 to 13 (Before reliability test).
oo: The ratio of acceptable liquid crystal panels was 99.5% or higher.
o: The ratio of acceptable liquid crystal panels was 95.0% or higher but lower than 99.5%.
x: The ratio of acceptable liquid crystal panels was lower than 95.0%.

### (4) Display Test of Liquid Crystal Panels after Connection Reliability Test

Twenty circuit boards with a semiconductor were selected from the circuit boards with a semiconductor evaluated as "acceptable" in the display test in the above (3), and were then left standing in a constant temperature and humidity chamber under conditions of 85°C and RH 60% for 168 hours for moisture absorption. Then, reflow soldering was performed under reflow conditions of 260°C and 5 seconds (moisture absorption-reflow process). Then, 10 of the 20 circuit boards with a semiconductor were subjected to 1000 thermal cycles each consisting of incubation at -40°C for 5 minutes and incubation at 125°C for 5 minutes, and the remaining 10 circuit boards with a semiconductor were subjected to 2000 thermal cycles. Then, each of the circuit boards with a semiconductor was incorporated into a liquid crystal substrate to produce a liquid crystal panel. All the liquid crystal panels using the circuit boards with a semiconductor subjected to 1000 or 2000 thermal cycles were subjected to a display test and evaluated according to the following criteria. The evaluation results are shown in Tables 1 to 13 (After reliability test/1000 cycles, 2000 cycles).
○: All the 10 liquid crystal panels displayed images.
×: Not all the 10 liquid crystal panels displayed images due to poor connection.

[Table 1]

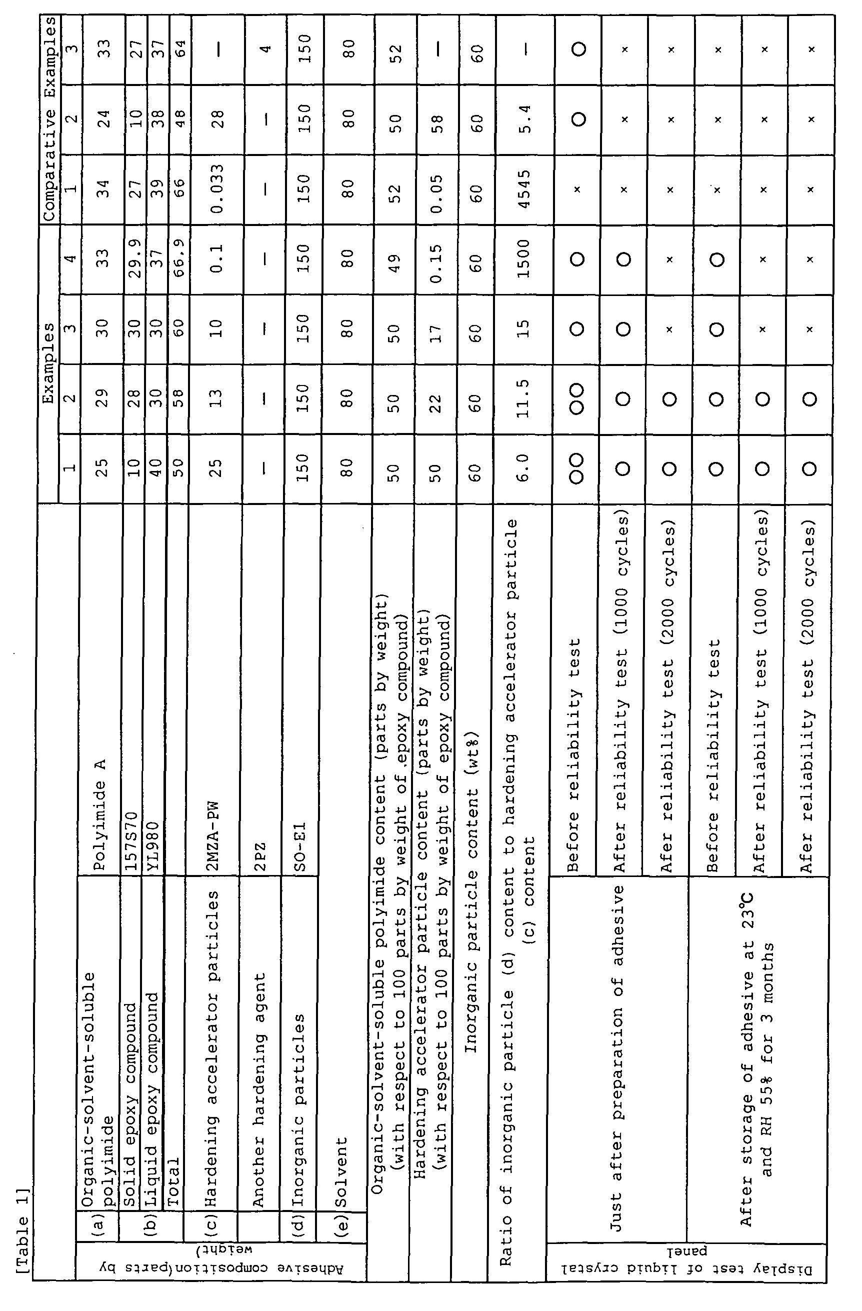

[Table 2]

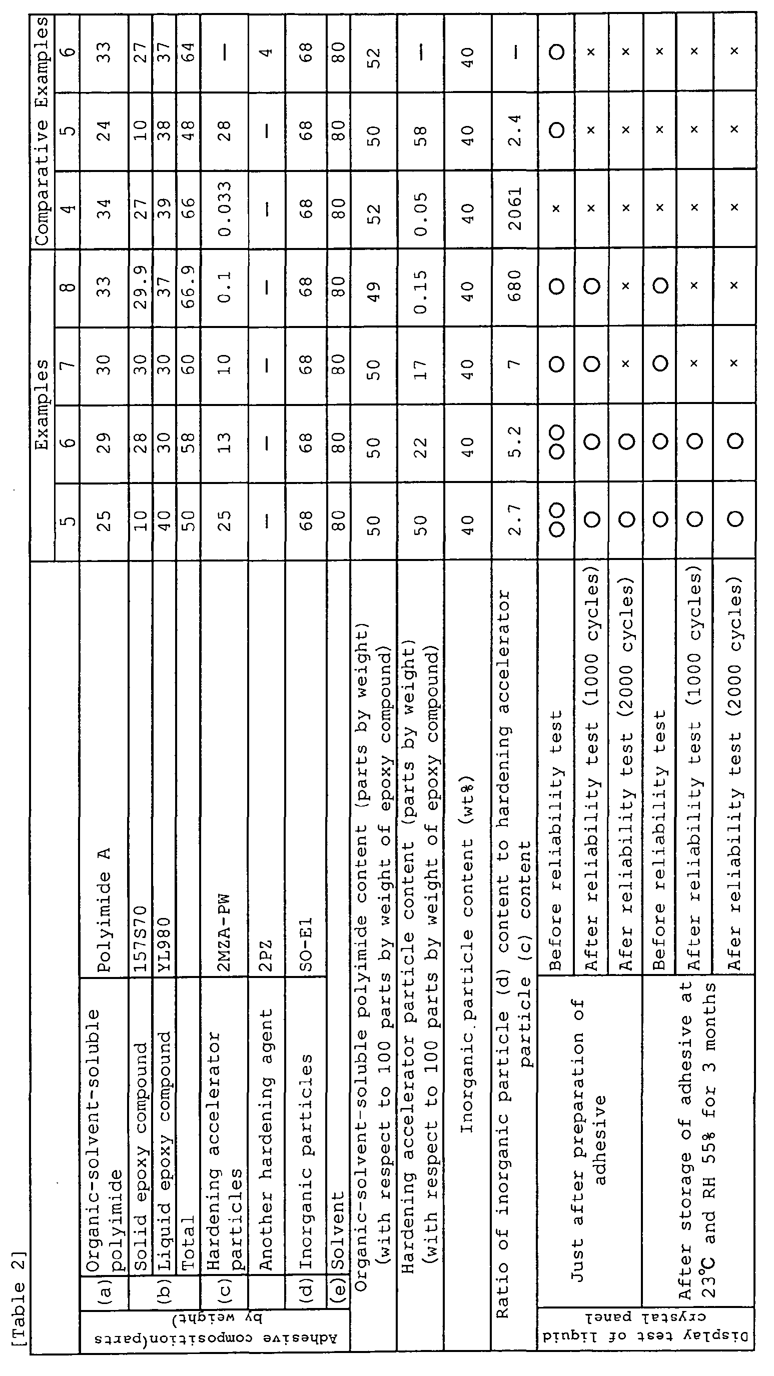

[Table 3]

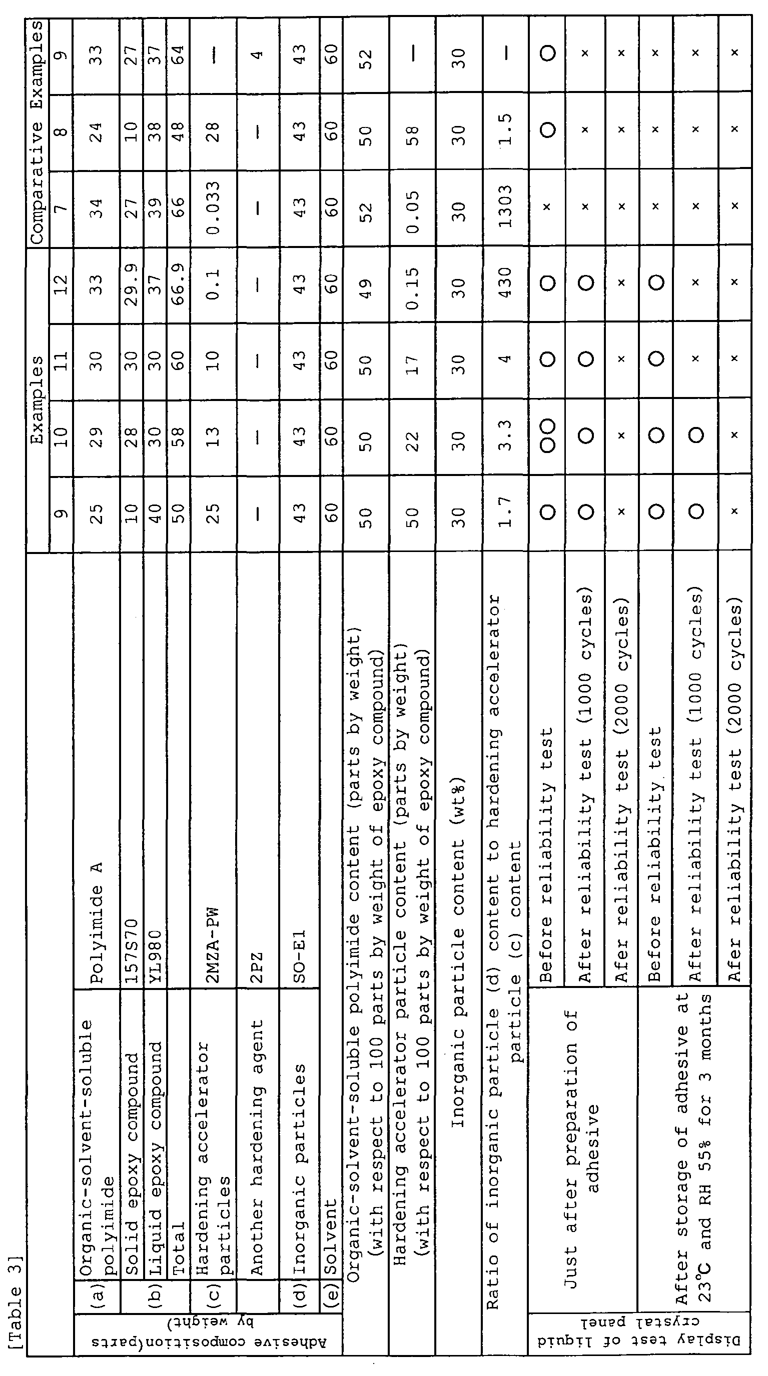

[Table 4]

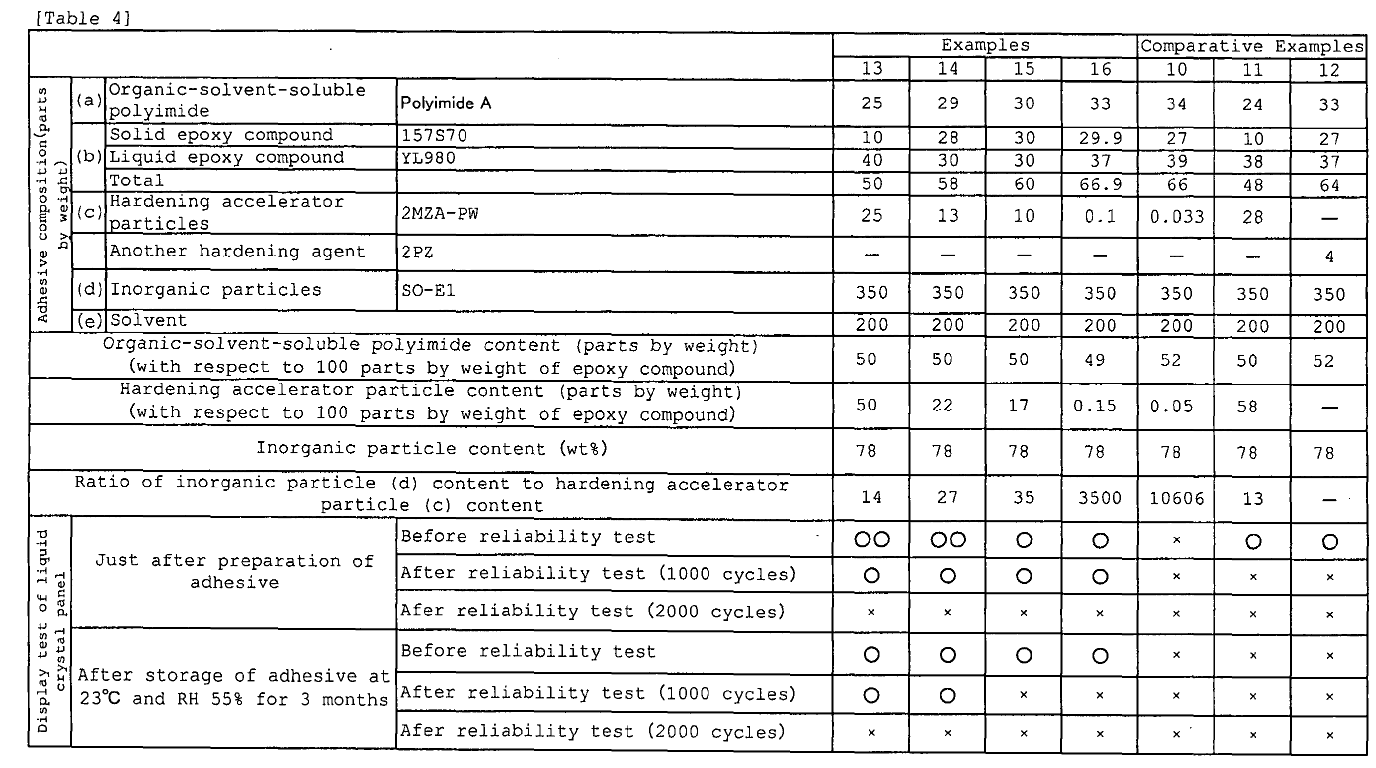

[Table 5]

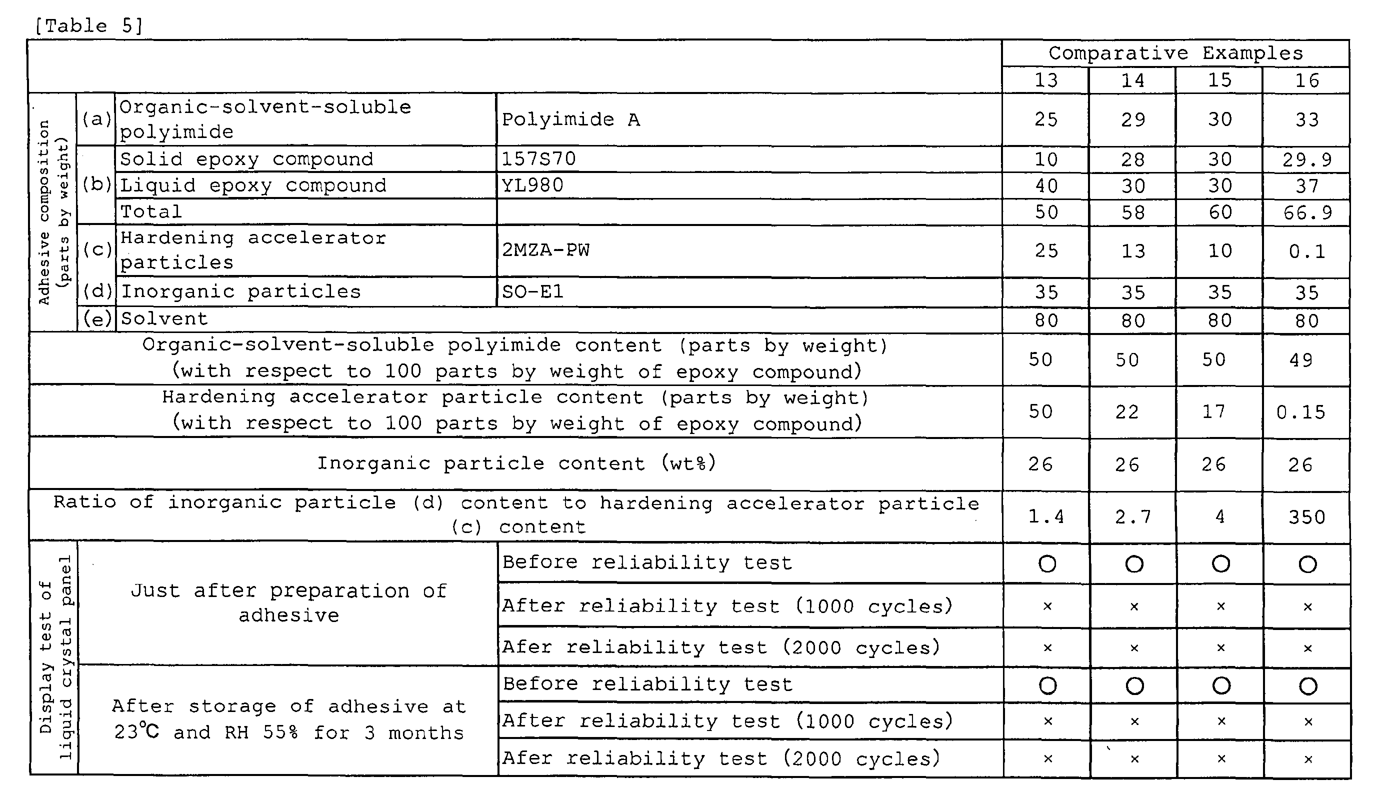

[Table 6]

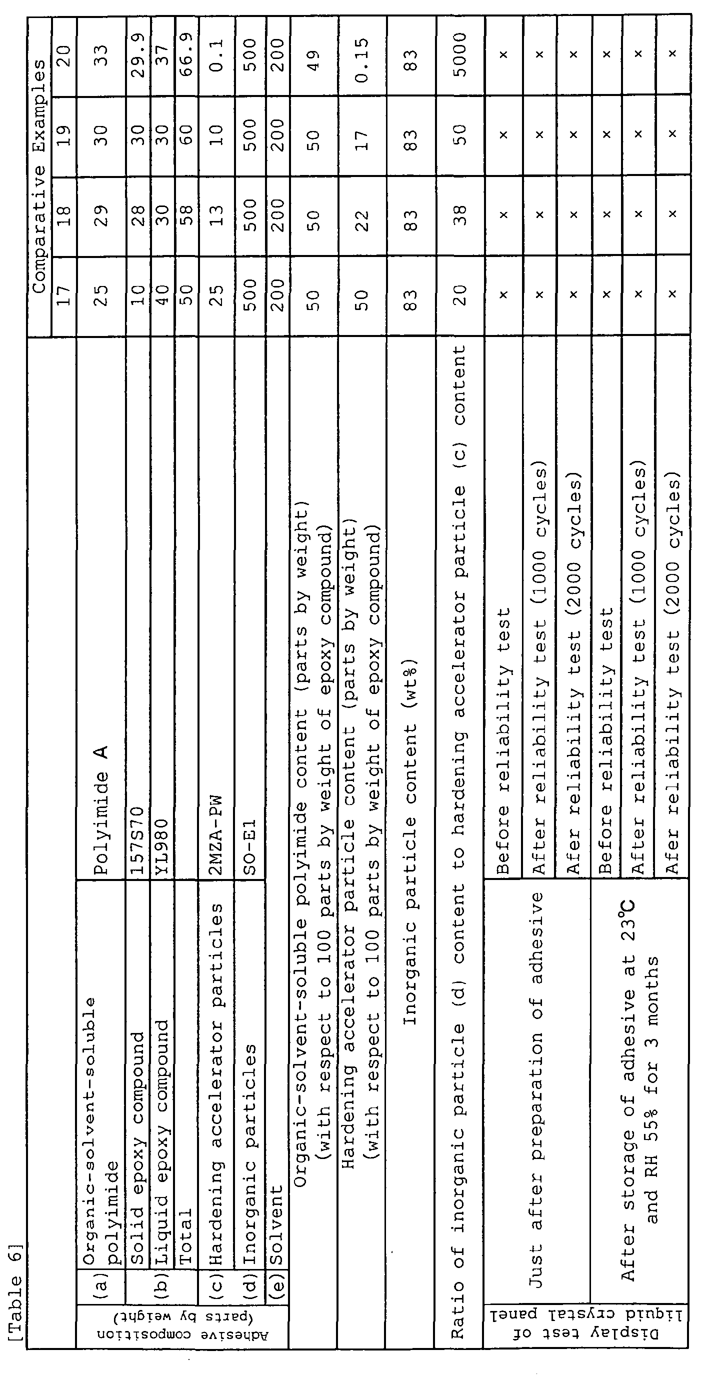

[Table 7]

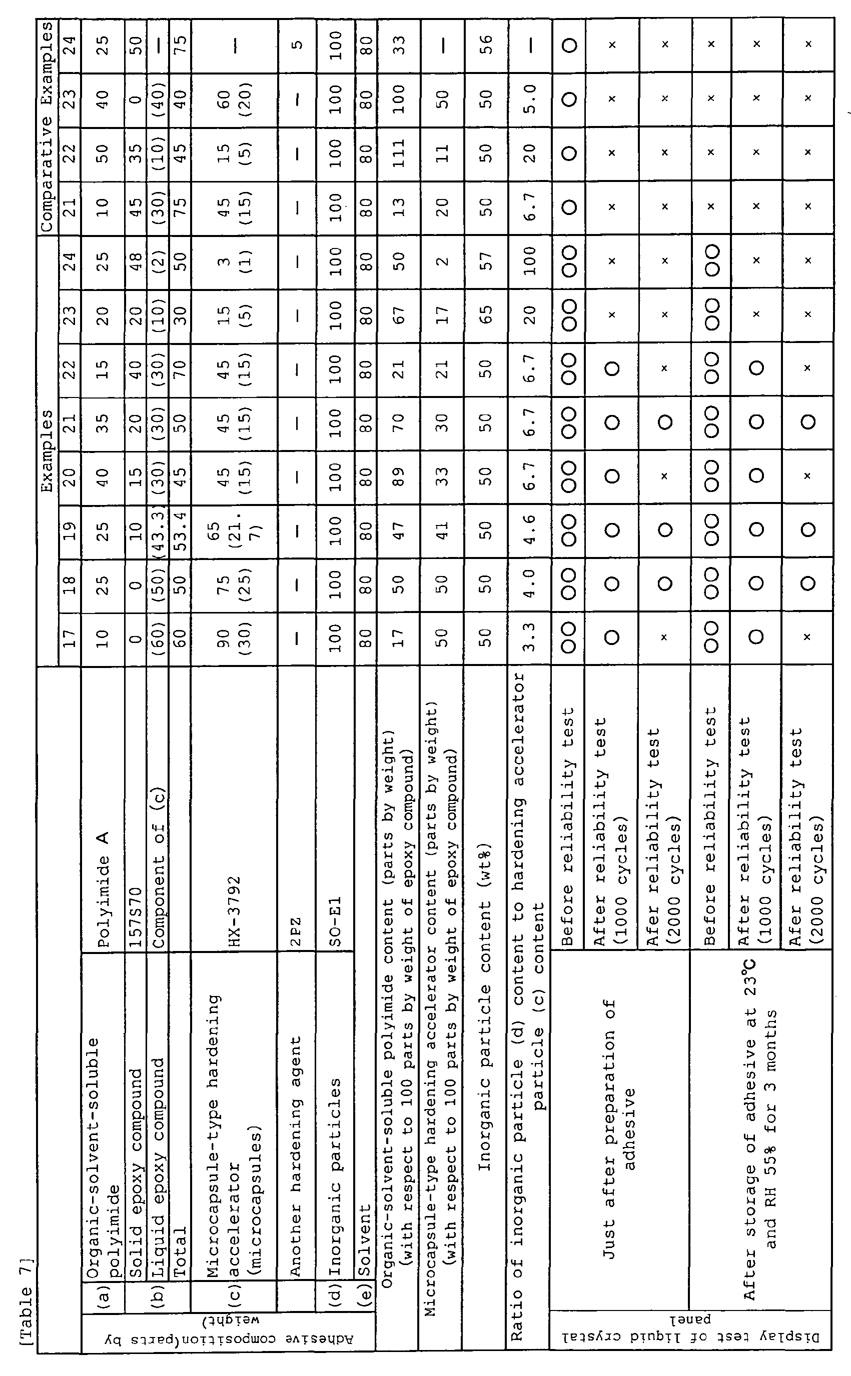

[Table 8]

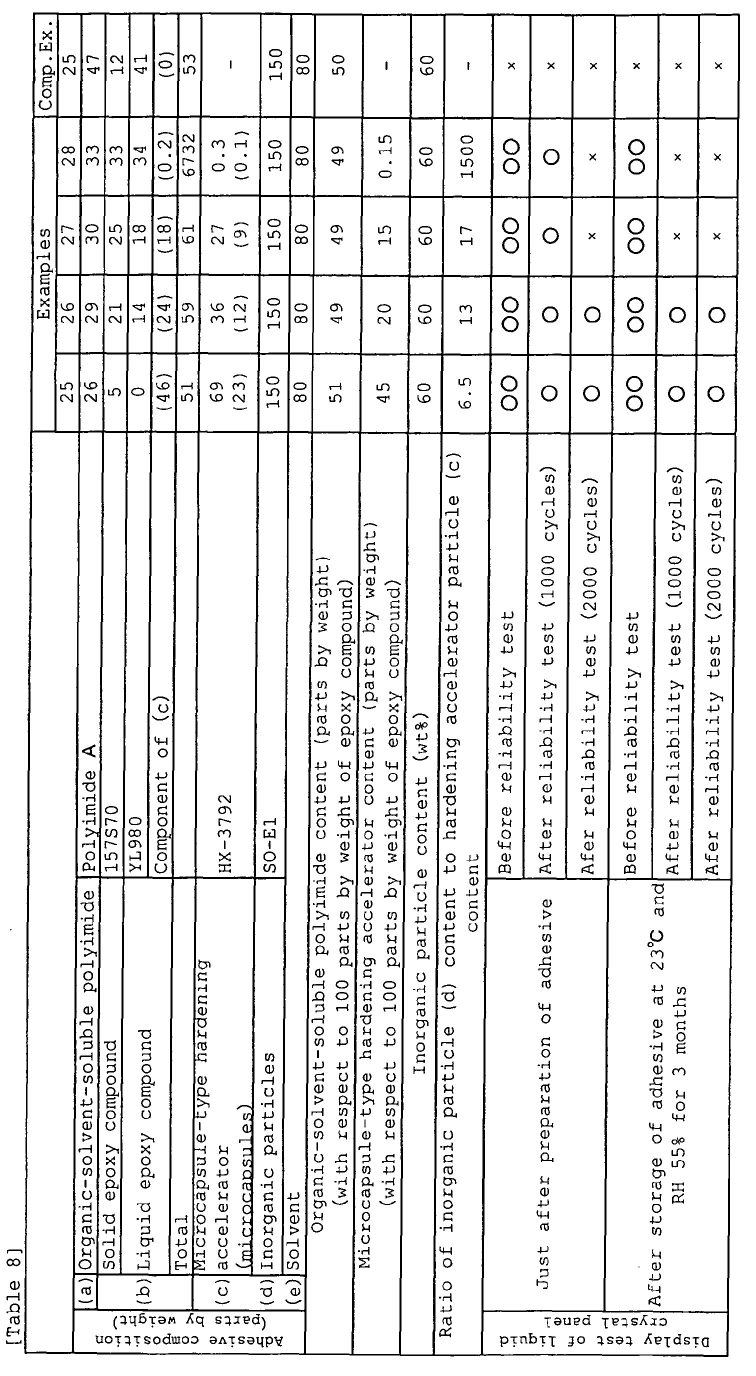

[Table 9]

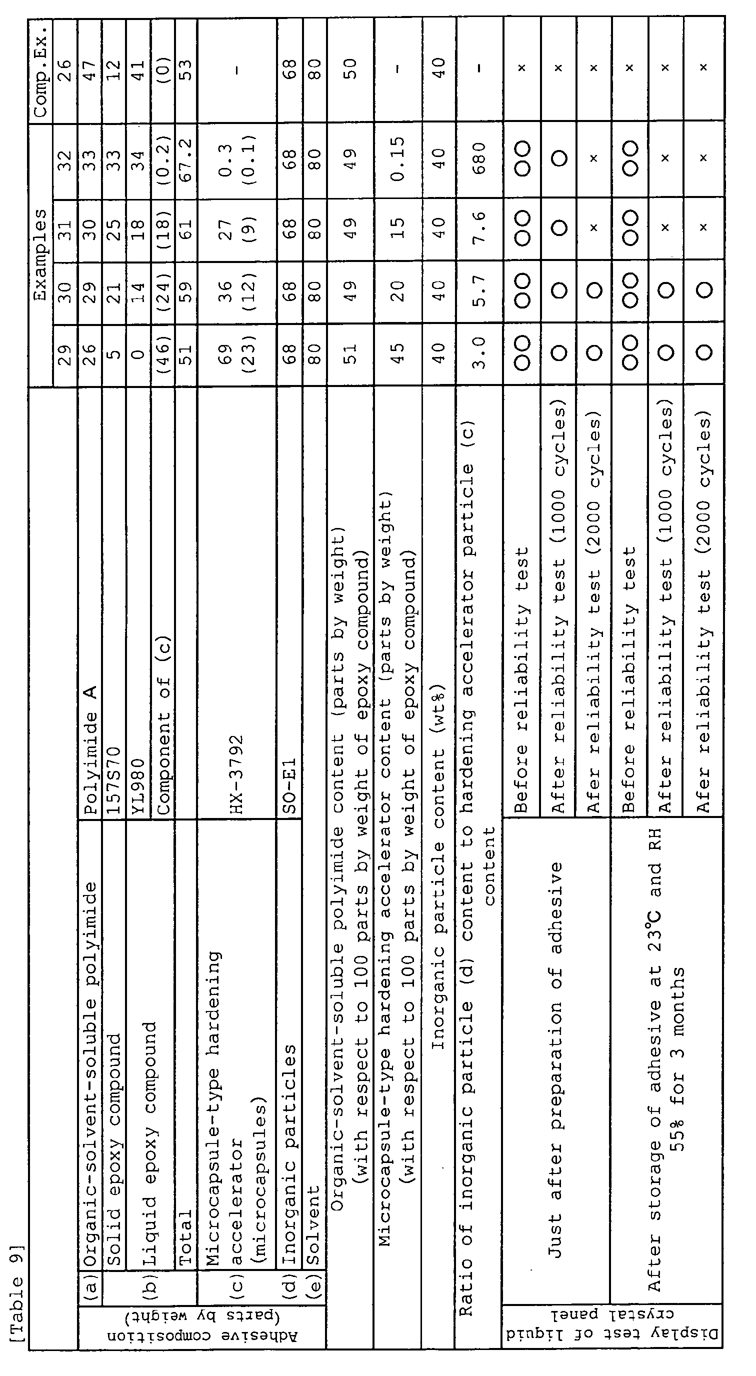

[Table 10]

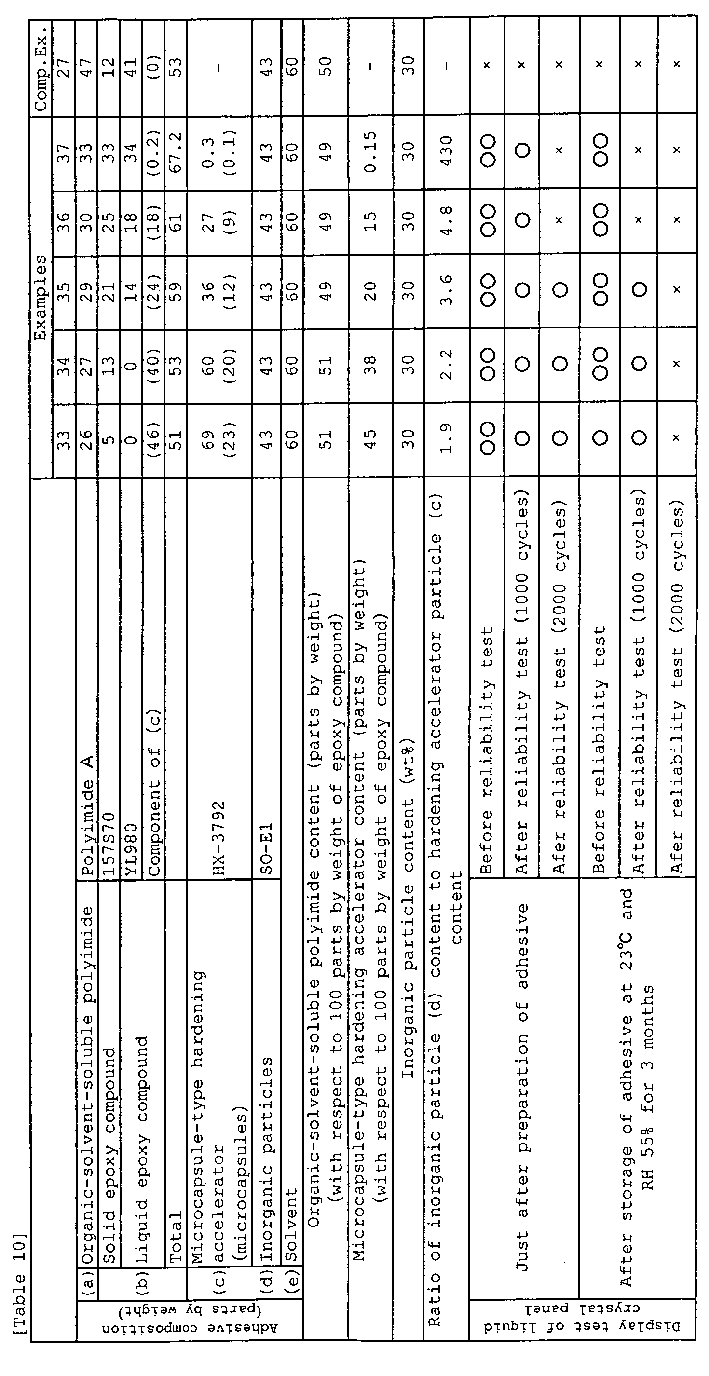

[Table 11]

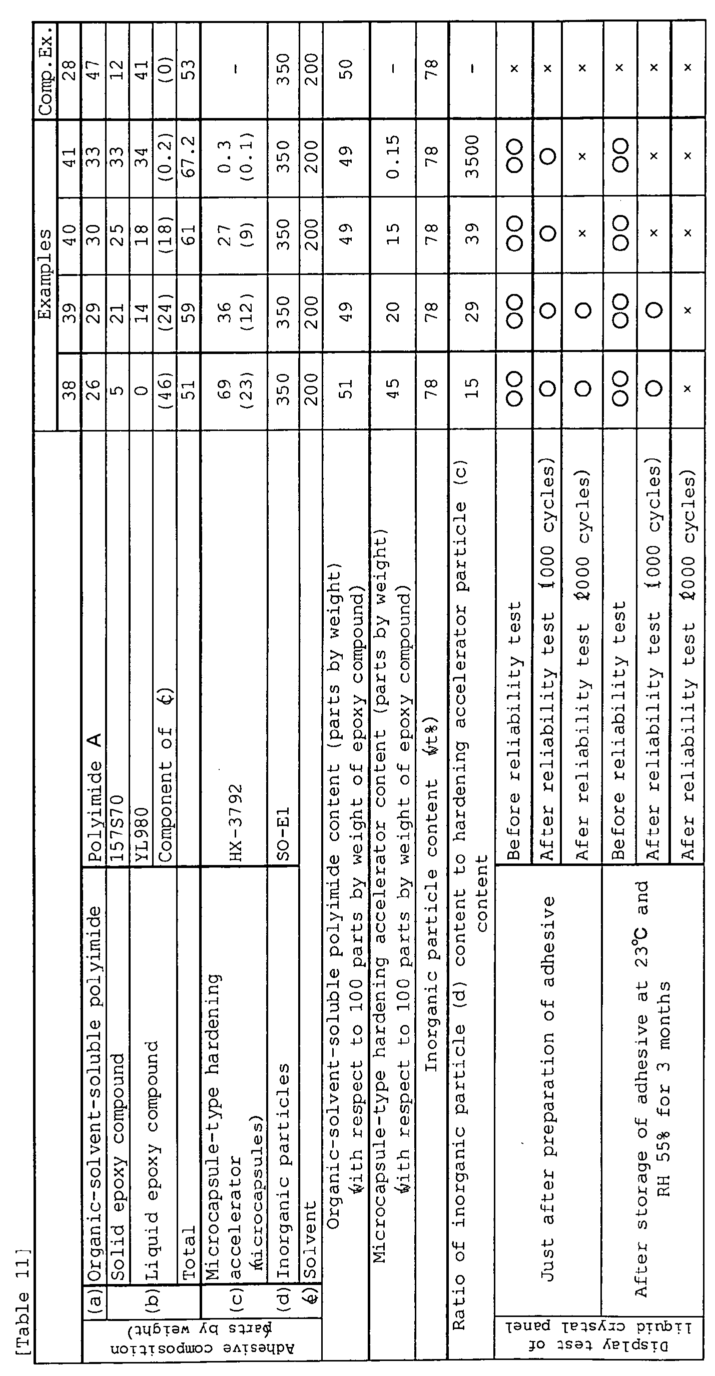

[Table 12]

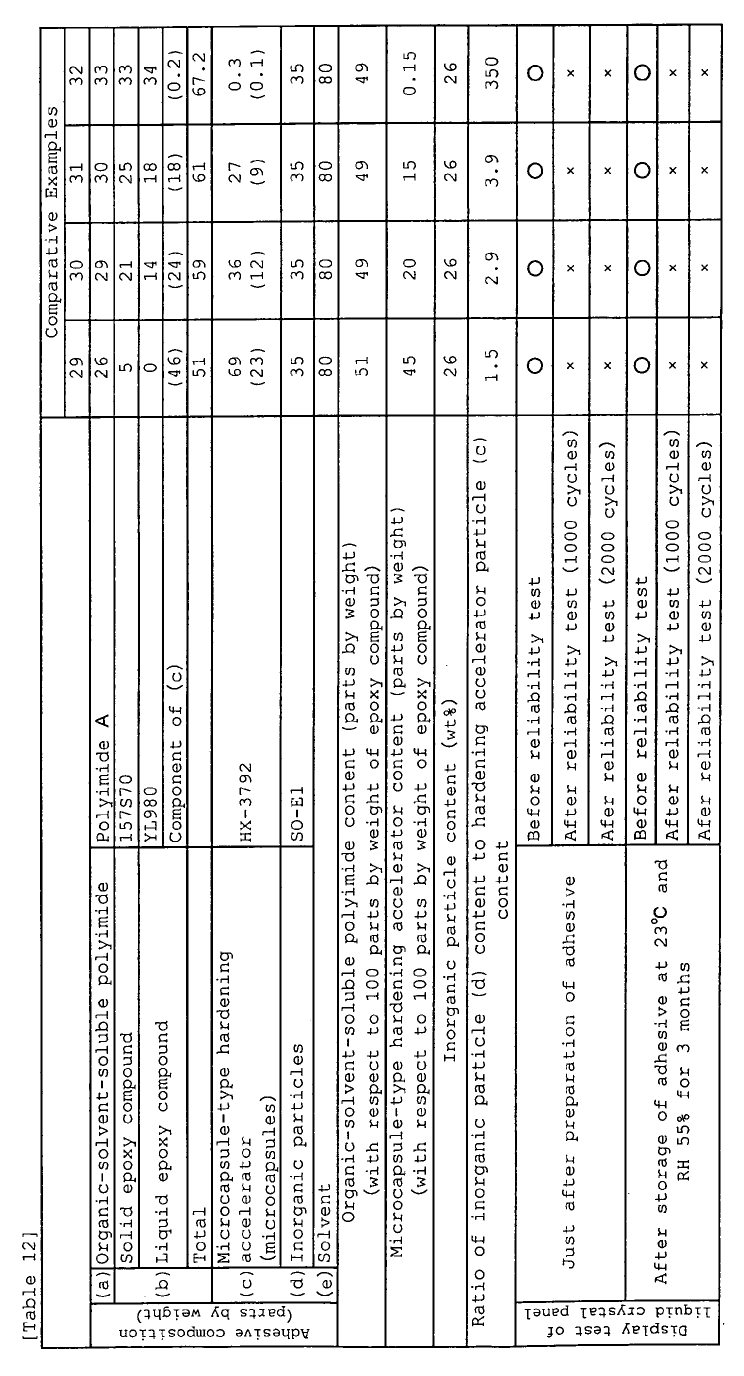

[Table 13]

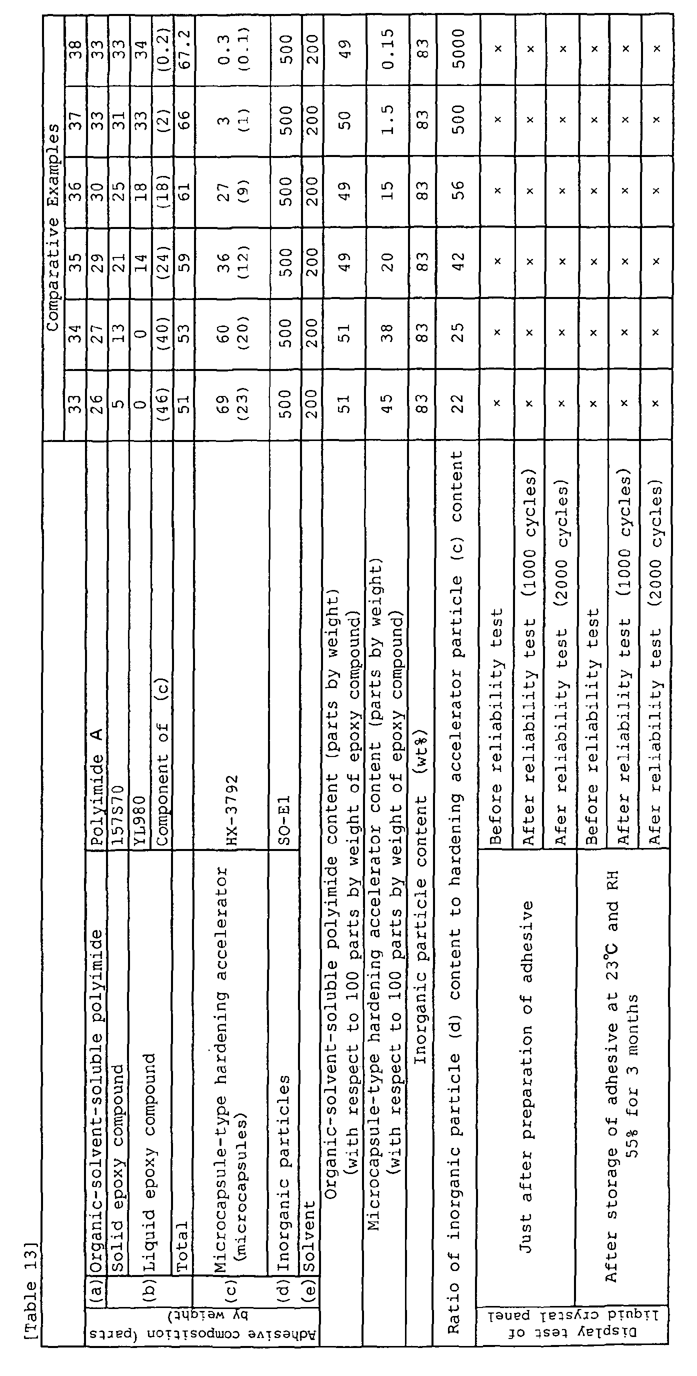

From the result of comparison between Examples 1 to 16 and Comparative Examples 1 to 12, it has been found that when the hardening accelerator particle content does not lie within the range specified in the present invention, it is difficult to maintain connection reliability when processes where higher durability is required, such as a moisture absorption-reflow process and a thermal cycle process, are performed. Further, it has been also found that when the hardening accelerator particle content does not lie within the range specified in the present invention, storage stability is poor and therefore connection reliability cannot be obtained at all when the tape roll is stored under conditions of 23°C and RH 55% for 3 months.

From the results of Comparative Examples 13 to 16, it has been found that when the inorganic particle content is lower than its lower limit specified in the present invention, it is difficult to maintain connection reliability when the moisture absorption-reflow process and the thermal cycle process are performed. Further, from the results of Comparative Examples 17 to 20, it has been found that when the inorganic particle content exceeds its upper limit specified in the present invention, connection reliability cannot be obtained at all when the moisture absorption-reflow process and the thermal cycle process are performed.

It is to be noted that the adhesive compositions of Comparative Examples 13 to 16 and 29 to 32 were foamed. In the master rolls obtained by winding the adhesive composition sheets of comparative Examples 17 to 20 and 33 to 38 into a roll shape, cracking or chipping was partially observed in their adhesive compositions.

### Examples 42 to 82 and Comparative Examples 39 to 76

Adhesive compositions for semiconductor were produced and evaluated in the same manner as in Examples 1 to 41 and Comparative Examples 1 to 38 except that the organic-solvent-soluble polyimide A was changed to the organic-solvent-soluble polyimide B. As a result, evaluation results similar to those of the display test of liquid crystal panels shown in Tables 1 to 13 were obtained.

### Examples 83 to 123 and Comparative Examples 77 to 114

Adhesive compositions for semiconductor were produced and evaluated in the same manner as in Examples 1 to 41 and Comparative Examples 1 to 38 except that the organic-solvent-soluble polyimide A was changed to the organic-solvent-soluble polyimide C. As a result, evaluation results similar to those of the display test of liquid crystal panels shown in Table 1 were obtained.

### Examples 124 to 164 and Comparative Examples 115 to 152

Adhesive compositions for semiconductor were produced and evaluated in the same manner as in Examples 1 to 41 and Comparative Examples 1 to 38 except that the inorganic particles SO-E1 were changed to the inorganic particles SO-E2. As a result, evaluation results similar to those of the display test of liquid crystal panels shown in Tables 1 to 13 were obtained.

### Examples 165 to 205 and Comparative Examples 153 to 190

Adhesive compositions for semiconductor were produced and evaluated in the same manner as in Examples 1 to 41 and Comparative Examples 1 to 38 except that the inorganic particles SO-E1 were changed to the inorganic particles SO-E3. As a result, evaluation results similar to those of the display test of liquid crystal panels shown in Tables 1 to 13 were obtained.

### Examples 206 to 217 and Comparative Example 191

Adhesive composition varnishes of Examples 206 to 217 and Comparative Example 191 were prepared by mixing their components in compounding ratios shown in Table 14 and dispersing the inorganic particles and the hardening accelerator particles with the use of a ball mill.

Each of the thus prepared adhesive composition varnishes having the composition ratios shown in Table 14 was applied onto the treated surface of a 75 µm-thick polyethylene terephthalate film (manufactured by Toray Advanced Film Co., Ltd. under the trade name of "Cerapeel HP2(U)", nonsilicone type, heavy release grade) as a release base material with the use of a slit die coater (coating machine), and was then dried at 80°C for 10 minutes to obtain an adhesive film for semiconductor. After drying, on the adhesive film for semiconductor having a thickness of 50 µm, a 38 µm-thick polyethylene terephthalate film (manufactured by Otsuki Industrial Co., Ltd. under the trade name of "SR-1", one-side release treated) was laminated as another release base material, and the adhesive film for semiconductor was wound around a paper core having an outer diameter of 9.6 cm into a roll shape in such a manner that the release base material Cerapeel HP2(U) was located inside to obtain a master roll of the adhesive film having a thickness of 50 µm. Then, the master roll was slit into a width of 7.5 mm with the use of a film slitter, and was then wound around reels having an outer diameter of 5.0 cm into a roll shape in such a manner that the release base material Cerapeel HP2(U) was located inside to obtain a tape roll having the adhesive composition whose both surfaces were covered with the release base materials. The thus obtained tape roll was divided into two groups depending on their storage conditions and evaluated. One was subjected to the processes (2) to (4) just after production and the other was stored under conditions of 23°C and RH 55% for 3 months and then subjected to the processes (2) to (4). Then, (2) tape attachment process, (3) flip-chip bonding and display test of liquid crystal panels, and (4) display test of liquid crystal panels after connection reliability test were performed in the same manner as in Example 1. The results are shown in Table 14.

[Table 14]

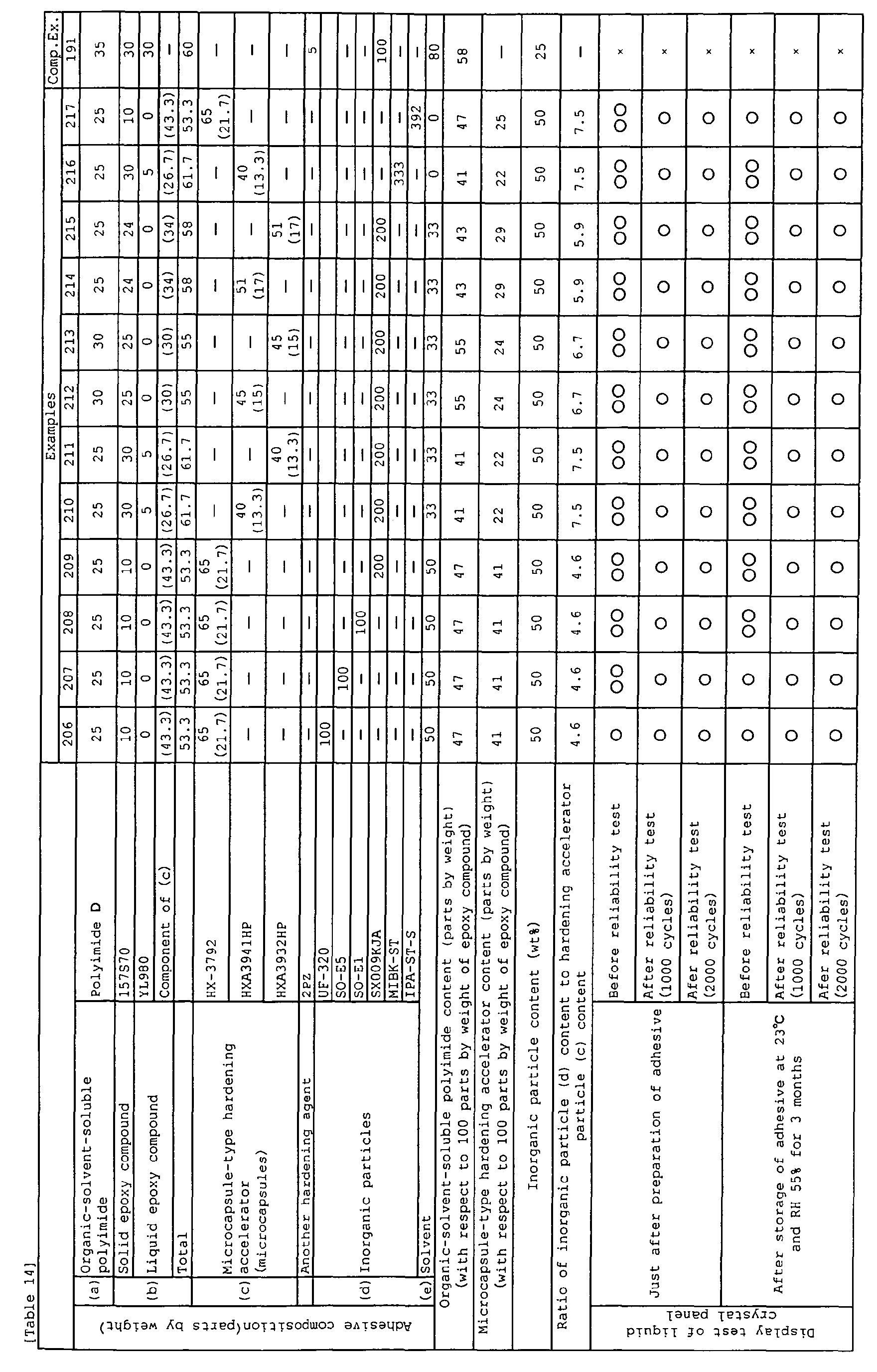

### Examples 218 to 229 and Comparative Example 192

Adhesive compositions for semiconductor were prepared and evaluated in the same manner as in Examples 206 to 217 and Comparative Example 191 except that the organic solvent soluble-polyimide D was changed to the organic-solvent-soluble polyimide E. The evaluation results are shown in Table 15.

[Table 15]

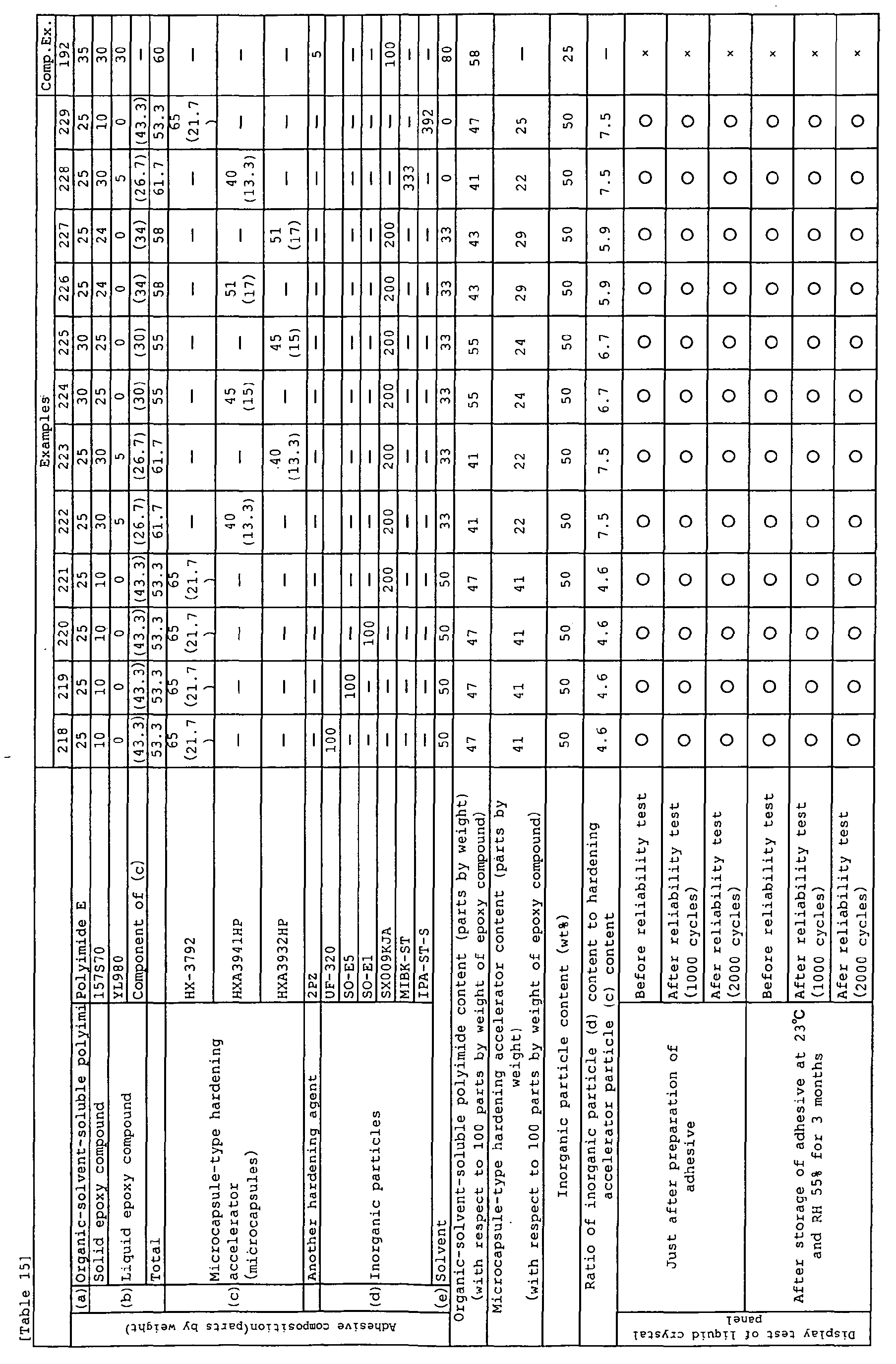

### Examples 230 to 241

Semiconductor devices were produced in the following manner using the master rolls prepared in Examples 206 and 217, respectively.

### (5) Process of Laminating Adhesive Film on Wafer with Bumps

Bump electrodes were embedded in the adhesive composition with the use of the adhesive film whose both surfaces were covered with the release base materials and a lamination machine (manufactured by Takatori Corporation under the trade name of VTM-200M).

First, the release base material SR-1 was peeled off from the master roll to expose the adhesive composition surface. Then, the adhesive film was laminated at a temperature of 80°C and a lamination speed of 20 mm/s on the bump electrode formation surface of a semiconductor wafer (diameter: 200 mm, thickness: 625 µm) with bump electrodes having an average height of 35 µm (448 bumps/chip, pitch: 60 µm, peripheral arrangement, gold stud bumps) fixed onto a stage of the lamination machine. The excess adhesive composition around the semiconductor wafer was cut off by a cutter blade. In this way, a semiconductor wafer whose bump electrodes were embedded in the adhesive covered with Cerapeel HP2(U) was obtained.

### (6) Dicing Process

First, the semiconductor wafer obtained in the above (5) was mounted on a tape frame and a dicing tape (manufactured by Lintec Corporation under the trade name of D-650) by attaching the dicing tape to the wafer substrate surface of the semiconductor wafer opposite to the bump electrode formation surface with the use of a wafer mounter (manufactured by TECHNOVISION, INC. under the trade name of FM-114) . Then, the release base material Cerapeel HP2(U) was peeled off. Prior to dicing, visibility for alignment was evaluated using a dicing machine. On the cutting stage of a dicing machine (manufactured by DISCO CORPORATION under the trade name of DAD-3350) , the tape frame was fixed so that the adhesive composition surface faced upward, and alignment was performed using a CCD camera of the dicing machine. A case where alignment marks could be detected by the auto alignment function of the dicing machine was evaluated as "o", and a case where alignment marks could not be detected was evaluated as "x" . The evaluation results are shown in Table 15 (Visibility for auto alignment).

Then, dicing was performed under the following cutting conditions.
Dicing machine: DAD-3350 (manufactured by DISCO CORPORATION)
Semiconductor chip size: 7.5 x 7.5 mm
Blade: NBC-ZH2030-27HCDE
Spindle rotational speed: 30,000 rpm
Dicing speed: 25 mm/s
Dicing depth: cut to a depth of 10 µm in dicing tape
Cutting method: one-pass full cutting
Cutting mode: down cutting
Amount of water for dicing: 3.7 L/min
Water for dicing and cooling water: temperature 23°C, electrical conductivity 0.5 MΩ·cm (carbon dioxide gas was injected into ultrapure water)

In this way, semiconductor chips (7.3 mm square) with the adhesive composition were obtained.

The semiconductor chips with the adhesive composition produced in the above (6) were flip-chip bonded to a circuit board (gold pad electrodes, a glass epoxy substrate with a circuit on which 300 7.5 mm-square semiconductor chips can be mounted). The connection of the semiconductor chips with the adhesive composition to the circuit board was performed by using a flip-chip bonding machine (manufactured by Toray Engineering Co., Ltd. under the trade name of FC-2000). The flip chip bonding was performed by fixing the circuit board to a bonding stage heated to 80°C, temporarily pressure-bonding the semiconductor chips under conditions of a temperature of 80°C and a pressure of 15 N/chip (with gold stud bump electrodes having an average height of 35 µm, 448 bumps/chip, pitch: 60 µm, peripheral arrangement, 7.5 mm-square chip) for 5 seconds, and finally pressure-bonding the semiconductor chips under conditions of a temperature of 200°C and a pressure of 200 N/chip for 10 seconds. After the completion of bonding, the circuit board was divided into circuit boards with a semiconductor by a substrate cutting machine. Each of the circuit boards with a semiconductor was incorporated into a liquid crystal substrate to produce a liquid crystal panel, and the liquid crystal panel was subjected to a display test and evaluated according to the following criteria.
○: Images were displayed.
○: The display test could not be performed due to a failure in detecting alignment marks in the dicing process or images were not displayed due to poor connection between the chip and the circuit board by flip chip bonding. The evaluation results are shown in Table 16.

[Table 16]

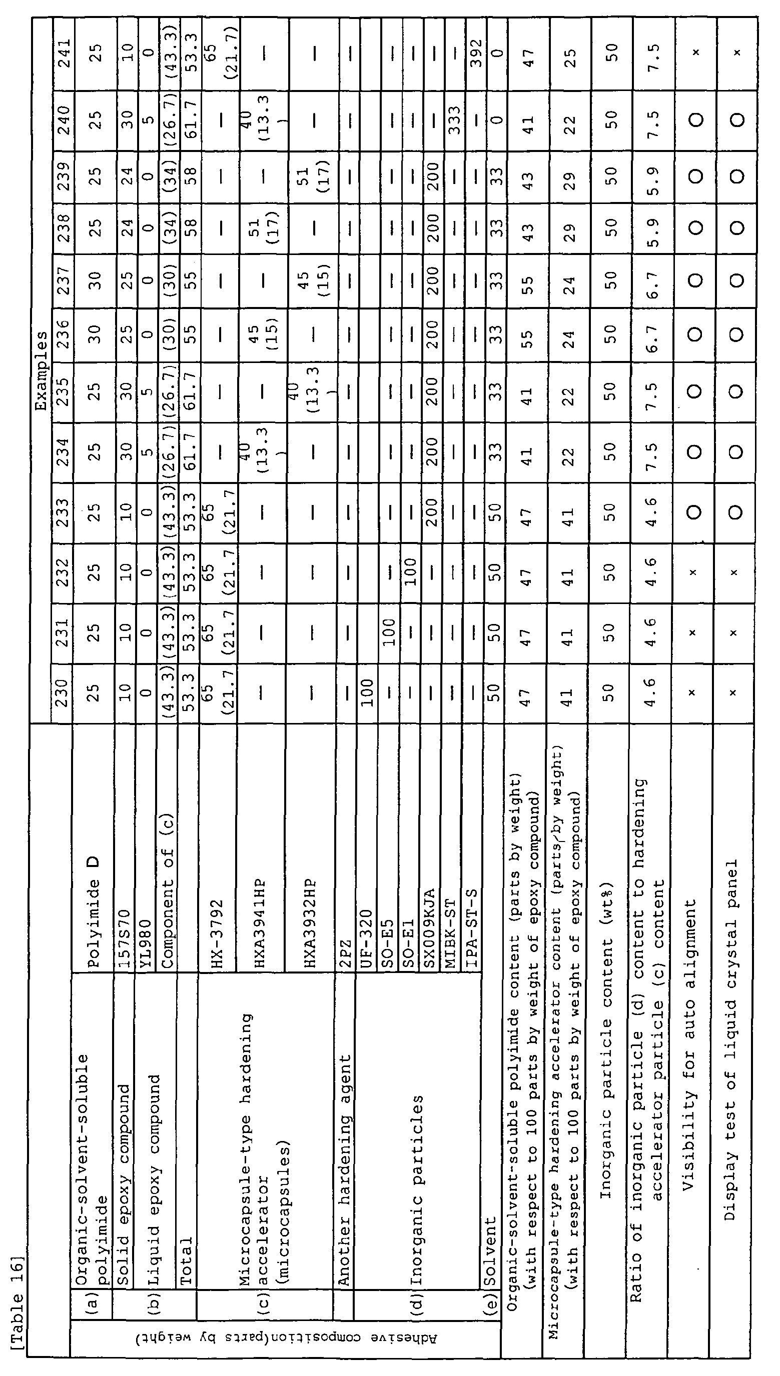

### Examples 242 to 253

Semiconductor devices were produced by mounting aluminum radiator plates on the semiconductors of the circuit boards with a semiconductor prepared in Examples 206 to 217 with the use of the master rolls having the 50 µm thick-adhesive composition film prepared in Examples 206 to 217, respectively.

First, the master roll was cut into a 7. 5 mm-square piece, and the release base material SR-1 was removed. The adhesive composition film was placed on the circuit board with a semiconductor in such a manner that the silicon surface of the circuit board with a semiconductor and the adhesive composition surface were brought into contact with each other, and was then pressure-bonded by a flat-plate pressing machine under conditions of 60°C, 2 s, and 0.1 MPa. Then, the release base material Cerapeel HP2(U) was peeled off to expose the adhesive composition surface. Then, an aluminum radiator plate was placed on the adhesive composition surface, and pressure-bonded by a flat-plate pressing machine under conditions of 200°C, 10 s, and 0. 1 MPa to obtain a semiconductor device with a radiator plate. The obtained semiconductor device with a radiator plate was left standing in a constant temperature and humidity chamber under conditions of 85°C and RH 60% for 168 hours for moisture absorption. Then, reflow soldering was performed under reflow _{.} conditions of 260°C for 5 seconds. Then, the circuit board with a semiconductor was subjected to 2000 thermal cycles each consisting of incubation at -40°C for 5 minutes and incubation at 125°C for 5 minutes. Then, the semiconductor device with a radiator plate was observed with an ultrasonic flaw detector to determine whether separation occurred between the radiator plate and the semiconductor chip. As a result, no separation was observed.

### Examples 254 to 265

A circuit board with a semiconductor having three silicon interposer layers (see Fig. 1) was produced using the circuit board with no adhesive composition used in the above (2) tape attachment process in Example 1, each of the 50 µm-thick adhesive composition sheets prepared in Examples 206 to 217, silicon interposers with TSV electrodes (silicon thickness: 50 µm, via diameter: 20 µm, copper through-via, solder-coated electrodes), and the semiconductor chip used in the above (3) flip chip bonding and display test of produced liquid crystal panels in Example 1. The circuit board with a semiconductor having three silicon interposers was incorporated into a liquid crystal substrate to produce a liquid crystal panel, and the liquid crystal panel was subjected to a display test. As a result, it was confirmed that images were displayed without any problem.

### INDUSTRIAL APPLICABILITY

The adhesive composition according to the present invention can be used as an adhesive for use in bonding of electronic parts for use in personal computers or mobile computers, bonding between a radiator plate and a printed substrate or a flexible substrate, or bonding between substrates. Further, the adhesive composition according to the present invention is suitable for use as an adhesive composition for semiconductor in bonding or direct electrical connection of a semiconductor chip such as IC or LSI to a circuit board such as a flexible substrate, a glass epoxy substrate, a glass substrate, or a ceramic substrate.

### DESCRIPTION OF REFERENCE SIGNS

- 1: Semiconductor
- 2: Stud bump
- 3: Adhesive composition
- 4: Silicon interposer with TSV electrodes
- 5: Copper through-via
- 6: Solder joint
- 7: Circuit board
- 8: Gold pad electrode

## Claims

1. An adhesive composition comprising:
an organic-solvent-soluble polyimide (a);
an epoxy compound (b);
hardening accelerator particles (c); and
inorganic particles (d), wherein an organic-solvent-soluble polyimide (a) content and a hardening accelerator particle (c) content are 15 to 90 parts by weight and 0.1 to 50 parts by weight, respectively, with respect to 100 parts by weight of the epoxy compound (b) , and an inorganic particle (d) content is 30 wt% or more but 80 wt% or less with respect to a total amount of (a) to (d).

2. The adhesive composition according to claim 1, wherein the hardening accelerator particles (c) is a microcapsule-type hardening accelerator.

3. The adhesive composition according to claim 1 or 2, wherein the organic-solvent-soluble polyimide (a) is a polymer having a structural unit represented by the following general formula (2), a structure(s) represented by the following general formula (3) and/or the following general formula (4) at least one of ends of its main chain, and a structure represented by the following general formula (1) as R⁴ in the general formula (2) in an amount of 5 to 15 wt% with respect to a total amount of the polymer, and wherein a hardening accelerator particle (c) content is 20 to 50 parts by weight with respect to 100 parts by weight of the epoxy compound (b): 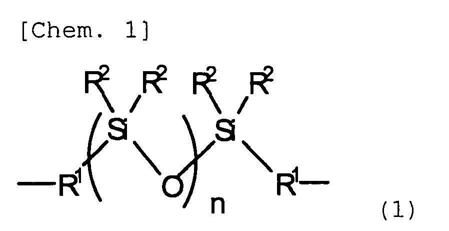 wherein R¹ is a divalent hydrocarbon group, R² is a monovalent hydrocarbon group, R¹s and R²s contained in one molecule of the organic-solvent-soluble polyimide may be different, R¹s and R²s contained in different molecules of the organic-solvent-soluble polyimide may be different, and n is an integer of 1 to 10; 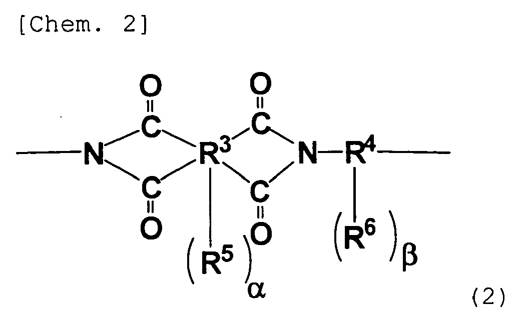 wherein R³ is a 4- to 14-valent organic group, R⁴ is a 2- to 12-valent organic group, at least one of R³ and R⁴ contains at least one group selected from the group consisting of a 1,1,1,3,3,3,-hexafluoropropyl group, an isopropyl group, an ether group, a thioether group, and a SO₂ group, R⁵ and R⁶ are each a group selected from the group consisting of a phenolic hydroxyl group, a sulfonic acid group, and a thiol group, R³s, R⁴s, R⁵S , and R⁶s contained in one molecule of the organic-solvent-soluble polyimide may be different, R³s, R⁴S, R⁵s, and R⁶s contained in different molecules of the organic-solvent-soluble polyimide may be different, α and β are each an integer of 0 to 10, and α+β is an integer of 1 to 10; 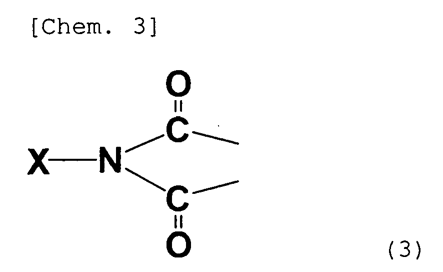 wherein X is a monovalent organic group; and 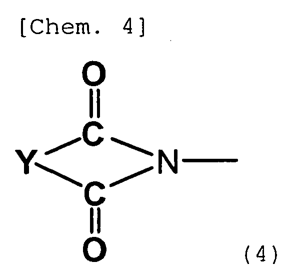 wherein Y is a divalent organic group.

4. The adhesive composition according to any one of claims 1 to 3, wherein the organic-solvent-soluble polyimide (a) is a polymer having a structure represented by either of the following general formula (5) or (6), at least one functional group reactable with an epoxy group in its side chain, and a structure represented by the general formula (1) as R⁴ in the general formulas (5) and (6) in an amount of 5 to 15 wt% with respect to a total amount of the polymer: 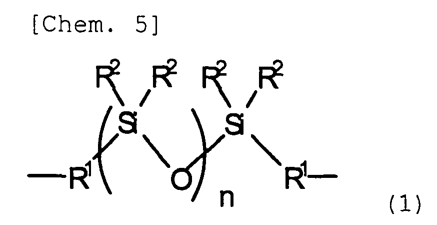 wherein R¹ is a divalent hydrocarbon group, R² is a monovalent hydrocarbon group, R¹s and R²s contained in one molecule of the organic-solvent-soluble polyimide may be different, R¹s and R²s contained in different molecules of the organic-solvent-soluble polyimide may be different, and n is an integer of 1 to 10; and 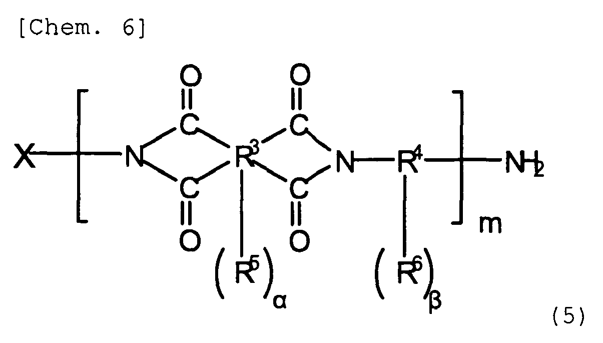 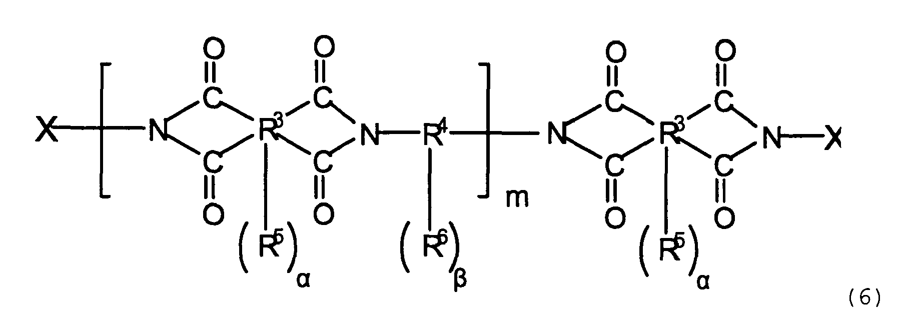 wherein R³ is a 4- to 14-valent organic group, R⁴ is a 2- to 12-valent organic group, at least one of R³ and R⁴ contains at least one group selected from the group consisting of a 1,1,1,3,3,3,-hexafluoropropyl group, an isopropyl group, an ether group, a thioether group, and a SO₂ group, R⁵ and R⁶ are each a group selected from the group consisting of a phenolic hydroxyl group, a sulfonic acid group, and a thiol group, R³s, R⁴s, R^{s}s, and R⁶s contained in one molecule of the organic-solvent-soluble polyimide may be different, R³s, R⁴s, R⁵s, and R⁶s contained in different molecules of the organic-solvent-soluble polyimide may be different, X is a monovalent organic group, m is 8 to 200, α and β are each an integer of 0 to 10, and α+β is an integer of 0 to 10, and wherein α+β is 1 to 10 in 20 to 90% of repeating units whose number is represented by m.

5. The adhesive composition according to any one of claims 1 to 4, wherein the inorganic particles (d) have an average particle size of 10 nm or more but 3 µm or less.

6. The adhesive composition according to any one of claims 1 to 5, wherein the inorganic particles (d) have an average particle size of 10 nm or more but 1 µm or less.

7. The adhesive composition according to any one of claims 1 to 6, wherein the inorganic particles (d) have an average particle size of 10 nm or more but 100 nm or less.

8. The adhesive composition according to any one of claims 1 to 7, wherein the inorganic particles are silica.

9. An adhesive sheet obtained by forming the adhesive composition according to any one of claims 1 to 8 into a sheet shape.

10. A hardened article of the adhesive composition according to any one of claims 1 to 8 or of the adhesive sheet according to claim 9.

11. A circuit board comprising a semiconductor chip bonded thereto using the adhesive composition according to any one of claims 1 to 8 or the adhesive sheet according to claim 9.

12. A method for producing a circuit board comprising a semiconductor chip mounted thereon, the method comprising: interposing the adhesive composition according to any one of claims 1 to 8 or the adhesive sheet according to claim 9 between a semiconductor chip and a circuit board; and electrically connecting the semiconductor chip and the circuit board to each other through application of heat and pressure.

13. A semiconductor device having a hardened article of the adhesive composition according to any one of claims 1 to 8 or a hardened article of the adhesive sheet according to claim 9.

14. A method for producing a semiconductor device, the method comprising: interposing the adhesive composition according to any one of claims 1 to 8 or the adhesive sheet according to claim 9 between a first circuit member and a second circuit member; and electrically connecting the first circuit member and the second circuit member to each other through application of heat and pressure.
